# EUROPEAN PATENT SPECIFICATION

(11) **EP 4 273 846 B1**
(45) Date of publication and mention of the grant of the patent: **18.11.2026**
(21) Application number: 21955352.6
(22) Date of filing: 30.08.2021
(51) Int. Cl.: G09G 3/32, H10K 59/00, G09G 3/3233

(54) **PIXEL CIRCUIT, PIXEL DRIVING METHOD, LIGHT-EMITTING SUBSTRATE, AND LIGHT-EMITTING DEVICE**
PIXELSCHALTUNG, PIXELANSTEUERUNGSVERFAHREN, LICHTEMITTIERENDES SUBSTRAT UND LICHTEMITTIERENDE VORRICHTUNG
CIRCUIT DE PIXELS, PROCÉDÉ DE COMMANDE DE PIXEL, SUBSTRAT ÉLECTROLUMINESCENT ET DISPOSITIF ÉLECTROLUMINESCENT

(43) Date of publication of application: 08.11.2023
(73) Proprietor: BOE Technology Group Co., Ltd., Beijing 100015 (CN); Beijing BOE Technology Development Co., Ltd., Beijing 100176 (CN)
(72) Inventor: SUN, Tuo, Beijing 100176 (CN); ZHOU, Ying, Beijing 100176 (CN); ZHANG, Yichi, Beijing 100176 (CN)
(74) Representative: Isarpatent
(86) International application number: PCT/CN2021/115407
(87) International publication number: WO 2023/028772

(56) References cited:
- CN-A- 103 021 334
- CN-A- 103 383 836
- CN-A- 113 257 185
- CN-A- 113 257 185
- JP-A- 2000 089 691
- KR-A- 20210 059 075
- US-A1- 2005 104 817
- US-A1- 2007 216 610
- US-A1- 2010 102 732
- US-A1- 2013 093 323
- US-A1- 2014 313 242
- US-A1- 2015 015 467
- US-A1- 2016 133 189
- US-A1- 2016 275 870
- US-A1- 2019 206 324
- US-A1- 2020 160 776
- US-A1- 2022 392 923

## Description

### TECHNICAL FIELD

The present disclosure relates to the technical field of photoelectricity, more particularly to a pixel circuit, a driving method of a pixel circuit, a light emitting base plate and a light emitting apparatus.

### BACKGROUND

For light emitting base plates of the structure of active-matrix organic light emitting diode (AMOLED) or active-matrix quantum dot light emitting diode (AMQLED), in order to ensure the uniformity of the brightness of the light emitting pixels, it is required to determine the driving voltage of the pixels according to the maximum value of the brightness of the light emitting pixels, and it is also required to ensure that the driving transistors of the light emitting pixels maintain outputting at the saturation region at a same time.

CN 113257185 A discloses a display panel, a display device and a light emitting element configuration method of the display panel. The display panel comprises a plurality of sub-pixels; each sub-pixel comprises a light emitting module, a gating module and a pixel driving circuit; the light emitting module comprises a first light emitting element and a second light emitting element; the gating module comprises a first gating unit, a second gating unit and a third gating unit; if the first gating unit is switched on, the second gating unit and the third gating unit are switched off, then the first light emitting element and the second light emitting element are connected in series; if the first gating unit is switched off, the second gating unit and the third gating unit are switched on, then the first light emitting element and the second light emitting element are connected in parallel. According to the display panel, the display device and the light emitting element configuration method of the display panel, the requirements of high manufacturing yield and low power consumption can be met at the same time.

US 2010/102732 A1 discloses a driver for a string of series arranged light emitting diodes of which at least two emit light having different spectra. The driver comprises a main power supply which has outputs coupled across the string to supply a main current to the string. A secondary power supply is coupled to at least one of junctions between successive light emitting diodes in the string to supply or withdraw a delta current from the junction. The delta current is at least a factor 5 smaller than the main current. A controller controls the secondary power supply to generate the delta current to obtain a desired spectral composition of the mixed light emitted by the string.

US 2013/093323 A1 discloses lighting devices for producing ultimate light comprising first light of a relatively warm color and second light of a relatively cool color. The lighting devices comprise first and second circuits for producing the first and second light, third circuits for reaching a temperature per intensity state of the ultimate light, and fourth circuits thermally coupled to the third circuits and comprising temperature-dependent circuits for giving the ultimate light a, for example, relatively warm color at lower intensity states and for giving the ultimate light a, for example, relatively cool color at higher intensity states. To this end, the third circuits may comprise resistors and/or diodes and/or zener diodes, and the temperature-dependent circuits may comprise negative temperature coefficient resistors connected in parallel to the first circuits or positive temperature coefficient resistors connected in parallel to the second circuits. Such a lighting device may provide black body line dimming.

US 2022/392923 A1 discloses a display device which may include a first scan line, a first data line and a second data line, a first read-out line and a second read-out line. A first sub-pixel may be connected to the first scan line, the first data line, and the first read-out line. A second sub-pixel may be connected to the first scan line, the first data line, and the second read-out line. A third sub-pixel may be connected to the first scan line, the second data line, and the first read-out line. Each of the first sub-pixel, the second sub-pixel, and the third sub-pixel may include at least one light emitting element.

### SUMMARY

This application provides a pixel circuit, a driving method of a pixel circuit, a light emitting base plate and a light emitting apparatus, as defined in the appended set of claims.

The present disclosure provides a pixel circuit, wherein the pixel circuit includes a first driving circuit, a first light emitting device, a second light emitting device and a second driving circuit that are sequentially connected in series;
the first driving circuit includes a first driving transistor, a source electrode of the first driving transistor is connected to a first power-supply terminal, and a drain electrode of the first driving transistor is connected to a first electrode of the first light emitting device;
the second driving circuit includes a second driving transistor, a source electrode of the second driving transistor is connected to a second power-supply terminal, and a drain electrode of the second driving transistor is connected to a first electrode of the second light emitting device;
a second electrode of the first light emitting device is connected to a second electrode of the second light emitting device; and
a channel type of the first driving transistor and a channel type of the second driving transistor are different;
wherein one of the first light emitting device and the second light emitting device is a light emitting device capable of emitting a blue light, and the other is a light emitting device capable of emitting a green light or a red light.

In an alternative implementation, the channel type of the first driving transistor is a P type, the channel type of the second driving transistor is an N type, the first electrode of the first light emitting device is an anode, the first electrode of the second light emitting device is a cathode, and a voltage inputted by the first power-supply terminal is greater than a voltage inputted by the second power-supply terminal; or
the channel type of the first driving transistor is an N type, the channel type of the second driving transistor is a P type, the first electrode of the first light emitting device is a cathode, the first electrode of the second light emitting device is an anode, and a voltage inputted by the first power-supply terminal is less than a voltage inputted by the second power-supply terminal.

In an alternative implementation, the pixel circuit further includes:
a bleeder component, connected to a first node, wherein the first node is connected to the second electrode of the first light emitting device and the second electrode of the second light emitting device, so that a difference between an electric current in the first light emitting device and an electric current in the second light emitting device is equal to an electric current in the bleeder component.

In an alternative implementation, the bleeder component includes a first transistor and a second transistor that have a same channel type;
a first electrode of the first transistor is connected to a first voltage inputting terminal, and a second electrode of the first transistor and a grid electrode of the first transistor are connected to the first node; and
a first electrode of the second transistor is connected to the first node, and a second electrode of the second transistor and a grid electrode of the second transistor are connected to a second voltage inputting terminal.

In an alternative implementation, the first driving circuit includes:
a first capacitor, wherein a first electrode of the first capacitor is connected to the first power-supply terminal, and a second electrode of the first capacitor is connected to a grid electrode of the first driving transistor;
a first resetting module configured for, at a first resetting stage, transmitting a signal of a first initialized-voltage terminal to the grid electrode of the first driving transistor and the second electrode of the first capacitor;
a first writing module configured for, at a first writing stage, writing a data signal of a first data writing terminal into the source electrode of the first driving transistor;
a first compensating module configured for, at the first writing stage, conducting the drain electrode of the first driving transistor with the grid electrode of the first driving transistor; and
a first light-emission controlling module configured for, at the first resetting stage and the first writing stage, disconnecting the source electrode of the first driving transistor from the first power-supply terminal, disconnecting the drain electrode of the first driving transistor from the first electrode of the first light emitting device, and, at a light-emission stage, conducting the source electrode of the first driving transistor with the first power-supply terminal, and conducting the drain electrode of the first driving transistor with the first electrode of the first light emitting device; and
the second driving circuit includes:
   a second capacitor, wherein a first electrode of the second capacitor is connected to the second power-supply terminal, and a second electrode of the second capacitor is connected to a grid electrode of the second driving transistor;
   a second resetting module configured for, at a second resetting stage, transmitting a signal of a second initialized-voltage terminal to the grid electrode of the second driving transistor and the second electrode of the second capacitor;
   a second writing module configured for, at a second writing stage, writing a data signal of a second data writing terminal into the source electrode of the second driving transistor;
   a second compensating module configured for, at the second writing stage, conducting the drain electrode of the second driving transistor with the grid electrode of the second driving transistor; and
   a second light-emission controlling module configured for, at the second resetting stage and the second writing stage, disconnecting the source electrode of the second driving transistor from the second power-supply terminal, disconnecting the drain electrode of the second driving transistor from the first electrode of the second light emitting device, and, at the light-emission stage, conducting the source electrode of the second driving transistor with the second power-supply terminal, and conducting the drain electrode of the second driving transistor with the first electrode of the second light emitting device.

The present disclosure provides a light emitting base plate, wherein the light emitting base plate includes the pixel circuit according to any one of the above embodiments.

In an alternative implementation, the light emitting base plate includes a plurality of pixel units, and the first light emitting device and the second light emitting device are located in a same pixel unit.

In an alternative implementation, in the same pixel unit, the pixel circuit further includes a third light emitting device and a third driving circuit;
the third driving circuit includes a third driving transistor, a source electrode of the third driving transistor is connected to the second power-supply terminal, and a drain electrode of the third driving transistor is connected to a first electrode of the third light emitting device;
a second electrode of the third light emitting device is connected to the second electrode of the first light emitting device and the second electrode of the second light emitting device; and
a channel type of the third driving transistor and the channel type of the second driving transistor are the same.

In an alternative implementation, the first light emitting device is a light emitting device capable of emitting a blue light, the second light emitting device is a light emitting device capable of emitting a green light, and the third light emitting device is a light emitting device capable of emitting a red light.

In an alternative implementation, the plurality of pixel units include a first pixel unit and/or a second pixel unit, and both of the first pixel unit and the second pixel unit includes the pixel circuit;
in the first pixel unit, the channel type of the first driving transistor is a P type, the channel type of the second driving transistor and the channel type of the third driving transistor are an N type, the first electrode of the first light emitting device is an anode, the first electrode of the second light emitting device and the first electrode of the third light emitting device are a cathode, and a voltage inputted by the first power-supply terminal is greater than a voltage inputted by the second power-supply terminal; and
in the second pixel unit, the channel type of the first driving transistor is an N type, the channel type of the second driving transistor and the channel type of the third driving transistor are a P type, the first electrode of the first light emitting device is a cathode, the first electrode of the second light emitting device and the first electrode of the third light emitting device are an anode, and a voltage inputted by the first power-supply terminal is less than a voltage inputted by the second power-supply terminal.

In an alternative implementation, when the plurality of pixel units include the first pixel unit and the second pixel unit, the first pixel unit and the second pixel unit satisfy any one of the following conditions:
the first pixel unit and the second pixel unit are located at different scanning lines of two neighboring scanning lines;
the first pixel unit and the second pixel unit are located at different data columns of two neighboring data columns; and
at least one of neighboring pixel units of the first pixel unit is the second pixel unit, and at least one of neighboring pixel units of the second pixel unit is the first pixel unit.

In an alternative implementation, the light emitting base plate includes a plurality of pixel units, the plurality of pixel units include a third pixel unit and a fourth pixel unit, the first light emitting device is located in the third pixel unit, and the second light emitting device is located in the fourth pixel unit.

In an alternative implementation, the third pixel unit includes one or more first sub-pixel units, each of the first sub-pixel units is provided with one instance of the first light emitting device and one instance of the first driving circuit, and the first light emitting devices in different instances of the first sub-pixel units are different;
the fourth pixel unit includes one or more second sub-pixel units, each of the second sub-pixel units is provided with one instance of the second light emitting device and one instance of the second driving circuit, and the second light emitting devices in different instances of the second sub-pixel units are different; and
the second electrode of any one of the first light emitting devices of the third pixel units is connected to the second electrodes of the second light emitting devices of the fourth pixel units.

In an alternative implementation, the third pixel unit and the fourth pixel unit are two neighboring pixel units, and the third pixel unit and the fourth pixel unit satisfy any one of the following conditions:
the third pixel unit and the fourth pixel unit are located at different scanning lines of two neighboring scanning lines;
the third pixel unit and the fourth pixel unit are located at different data columns of two neighboring data columns; and
a neighboring pixel unit of the third pixel unit is the fourth pixel unit, and a neighboring pixel unit of the fourth pixel unit is the third pixel unit.

In an alternative implementation, the channel types of the first driving transistors in the third pixel units are a P type, the first electrodes of the first light emitting devices are an anode, the channel types of the second driving transistors in the fourth pixel units are an N type, the first electrodes of the second light emitting devices are a cathode, and a voltage inputted by the first power-supply terminal is greater than a voltage inputted by the second power-supply terminal; or
the channel types of the first driving transistors in the third pixel units are an N type, the first electrodes of the first light emitting devices are a cathode, the channel types of the second driving transistors in the fourth pixel units are a P type, the first electrodes of the second light emitting devices are an anode, and a voltage inputted by the first power-supply terminal is less than a voltage inputted by the second power-supply terminal.

The present disclosure provides a light emitting apparatus, wherein the light emitting apparatus includes the light emitting base plate according to any one of the above embodiments.

The present disclosure provides a driving method of a pixel circuit, wherein the method is for driving the pixel circuit according to any one of the above embodiments, and the driving method includes:
at the light-emission stage, controlling the first light emitting device and the second light emitting device to synchronously emit light.

In an alternative implementation, when the first driving circuit includes the first capacitor, the first resetting module, the first writing module, the first compensating module and the first light-emission controlling module, and the second driving circuit includes the second capacitor, the second resetting module, the second writing module, the second compensating module and the second light-emission controlling module, before the light-emission stage, the method further includes:
at the first resetting stage, controlling the signal of the first initialized-voltage terminal to be transmitted to the grid electrode of the first driving transistor and the second electrode of the first capacitor, controlling the source electrode of the first driving transistor to be disconnected from the first power-supply terminal, and controlling the drain electrode of the first driving transistor to be disconnected from the first electrode of the first light emitting device;
at the first writing stage, controlling the data signal of the first data writing terminal to be written into the source electrode of the first driving transistor, controlling the drain electrode of the first driving transistor to be conducted with the grid electrode of the first driving transistor, controlling the source electrode of the first driving transistor to be disconnected from the first power-supply terminal, and controlling the drain electrode of the first driving transistor to be disconnected from the first electrode of the first light emitting device;
at the second resetting stage, controlling the signal of the second initialized-voltage terminal to be transmitted to the grid electrode of the second driving transistor and the second electrode of the second capacitor, controlling the source electrode of the second driving transistor to be disconnected from the second power-supply terminal, and controlling the drain electrode of the second driving transistor to be disconnected from the first electrode of the second light emitting device; and
at the second writing stage, controlling the data signal of the second data writing terminal to be written into the source electrode of the second driving transistor, controlling the drain electrode of the second driving transistor to be conducted with the grid electrode of the second driving transistor, controlling the source electrode of the second driving transistor to be disconnected from the second power-supply terminal, and controlling the drain electrode of the second driving transistor to be disconnected from the first electrode of the second light emitting device;
at the light-emission stage, the method further includes: controlling the source electrode of the first driving transistor to be conducted with the first power-supply terminal, controlling the drain electrode of the first driving transistor to be conducted with the first electrode of the first light emitting device, controlling the source electrode of the second driving transistor to be conducted with the second power-supply terminal, and controlling the drain electrode of the second driving transistor to be conducted with the first electrode of the second light emitting device; and
the second resetting stage and the first writing stage proceed synchronously.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the related art, the figures that are required to describe the embodiments or the related art will be briefly introduced below. Apparently, the figures that are described below are embodiments of the present disclosure, and a person skilled in the art can obtain other figures according to these figures without paying creative work. It should be noted that the proportions in the drawings are merely illustrative and do not indicate the actual proportions.
FIG. 1 schematically shows a schematic structural diagram of a pixel circuit in the related art;
FIG. 2 schematically shows a schematic structural diagram of the first type of the pixel circuit;
FIG. 3 schematically shows a schematic structural diagram of the second type of the pixel circuit;
FIG. 4 schematically shows a schematic sectional structural diagram of the first type of the pixel circuit;
FIG. 5a schematically shows a schematic diagram of the electric-current flowing direction of a pixel circuit;
FIG. 5b schematically shows a schematic diagram of the electric-current flowing direction of another pixel circuit;
FIG. 6 schematically shows an electric-current simulating diagram of a pixel circuit;
FIG. 7 schematically shows a schematic sectional structural diagram of a pixel circuit;
FIG. 8 schematically shows a particular schematic structural diagram of a pixel circuit;
FIG. 9 schematically shows a sequence diagram of the signal inputting of the input terminals of a pixel circuit;
FIG. 10a schematically shows a schematic diagram of the electric-circuit state of a pixel circuit at the first resetting stage;
FIG. 10b schematically shows a schematic diagram of the electric-circuit state of a pixel circuit at the first writing stage and the second resetting stage;
FIG. 10c schematically shows a schematic diagram of the electric-circuit state of a pixel circuit at the second writing stage;
FIG. 10d schematically shows a schematic diagram of the electric-circuit state of a pixel circuit at the light-emission stage;
FIG. 11 schematically shows a schematic structural diagram of the first type of the light emitting base plate;
FIG. 12 schematically shows a schematic structural diagram of the second type of the light emitting base plate;
FIG. 13 schematically shows a schematic structural diagram of the third type of the light emitting base plate;
FIG. 14 schematically shows a schematic structural diagram of the fourth type of the light emitting base plate;
FIG. 15 schematically shows a schematic structural diagram of the fifth type of the light emitting base plate; and
FIG. 16 schematically shows a schematic structural diagram of the sixth type of the light emitting base plate.

### DETAILED DESCRIPTION

In order to make the objects, the technical solutions and the advantages of the embodiments of the present disclosure clearer, the technical solutions of the embodiments of the present disclosure will be clearly and completely described below with reference to the drawings of the embodiments of the present disclosure. Apparently, the described embodiments are merely certain embodiments of the present disclosure, rather than the embodiments. The other embodiments that a person skilled in the art obtains on the basis of the embodiments of the present disclosure without paying creative work fall within the protection scope of the present disclosure.

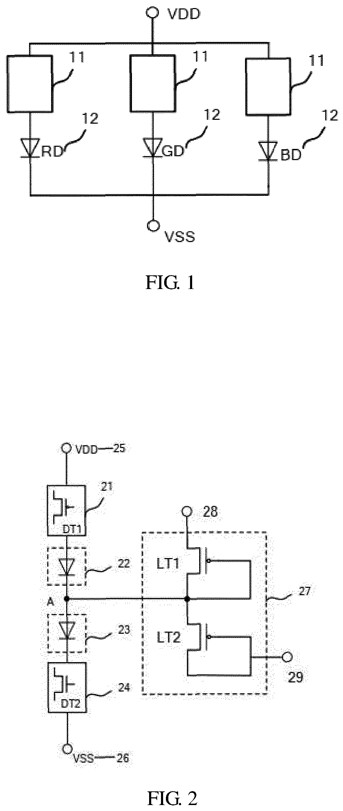

Light emitting base plates of the structure of AMQLED or AMOLED may include a plurality of light emitting sub-pixels. In the related art, a light emitting sub-pixel is generally formed by connecting sequentially a first power-supply terminal VDD, a pixel driving circuit 11, a light emitting device 12 and a second power-supply terminal VSS, as shown in FIG. 1. When the transistor characteristics of the pixel driving circuits 11 are close, the magnitude of the voltage between the first power-supply terminal VDD and the second power-supply terminal VSS is mainly decided by the driving voltage of the light emitting device 12. Because the driving voltage of the blue-light device BD is far greater than the driving voltages of the red-light device RD and the green-light device GD, in order to ensure the normal light emission of the blue-light device BD, the magnitude of the voltage between the first power-supply terminal VDD and the second power-supply terminal VSS is decided by the driving voltage of the blue-light device BD, which results in that the driving voltages that are actually required by the red-light device RD and the green-light device GD are far lower than the voltage that is actually applied to the red-light device RD and the green-light device GD, which results in that a large amount of excessive voltage is applied to the red-light device RD and the green-light device GD, thereby causing increasing of the heating quantity and a waste of the power consumption.

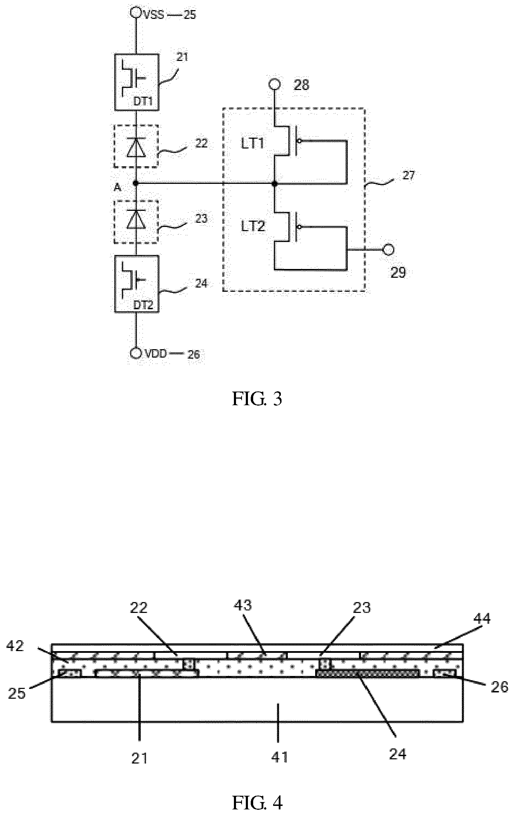

An embodiment of the present disclosure provides a pixel circuit. Referring to FIGs. 2 and 3, FIGs. 2 and 3 individually schematically show a schematic structural diagram of the pixel circuit according to the present disclosure. As shown in FIGs. 2 and 3, the pixel circuit includes a first driving circuit 21, a first light emitting device 22, a second light emitting device 23 and a second driving circuit 24 that are sequentially connected in series.

The first driving circuit 21 includes a first driving transistor DT1, the source electrode of the first driving transistor DT1 is connected to a first power-supply terminal 25, and the drain electrode of the first driving transistor DT1 is connected to a first electrode of the first light emitting device 22.

The second driving circuit 24 includes a second driving transistor DT2, the source electrode of the second driving transistor DT2 is connected to a second power-supply terminal 26, and the drain electrode of the second driving transistor DT2 is connected to a first electrode of the second light emitting device 23.

A second electrode of the first light emitting device 22 is connected to a second electrode of the second light emitting device 23.

The channel type of the first driving transistor DT1 and the channel type of the second driving transistor DT2 are different.

The channel types of transistors include a P type and an N type. When the channel type of one of the first driving transistor DT1 and the second driving transistor DT2 is the P type, the channel type of the other is the N type. The particular channel types of the first driving transistor DT1 and the second driving transistor DT2 are not limited in the present embodiment.

One of the first power-supply terminal 25 and the second power-supply terminal 26 is a high-level-signal inputting terminal, and the other is a low-level-signal inputting terminal, which is not limited in the present embodiment. The high-level-signal inputting terminal inputs a high-level signal VDD, and the low-level-signal inputting terminal inputs a low-level signal VSS.

In the present embodiment, when the channel type of one of the first driving transistor DT1 and the second driving transistor DT2 is the P type, and the channel type of the other is the N type, the source electrode of the P-type driving transistor is connected to the high-level-signal inputting terminal, and the source electrode of the N-type driving transistor is connected to the low-level-signal inputting terminal.

In an alternative implementation, as shown in FIG. 2, the channel type of the first driving transistor DT1 is a P type, and the channel type of the second driving transistor DT2 is an N type. In such a case, the voltage signal inputted by the first power-supply terminal 25 is the high-level signal VDD, and the voltage signal inputted by the second power-supply terminal 26 is the low-level signal VSS. In the present implementation, the first electrode of the first light emitting device 22 is an anode, the second electrode of the first light emitting device 22 is a cathode, the first electrode of the second light emitting device 23 is a cathode, and the second electrode of the second light emitting device 23 is an anode.

Referring to FIG. 4, FIG. 4 shows a schematic sectional structural diagram of the pixel circuit according to the present implementation. As shown in FIG. 4, the pixel circuit shown in FIG. 2 is disposed on a substrate 41, and between the first light emitting device 22 and the first driving circuit 21, a medium layer 42 is disposed between the second light emitting device 23 and the second driving circuit 24, and a pixel defining layer 43 is disposed between the first light emitting device 22 and the second light emitting device 23. The electrode layer 44 in FIG. 4 also serves as the cathode of the first light emitting device 22 and the anode of the second light emitting device 23, and the first light emitting device 22 and the second light emitting device 23 realize the cathode-anode connection by using the electrode layer 44 vapor-deposited on the surfaces. The first light emitting device 22 in FIG. 4 is of an uprightly placed structure, and the second light emitting device 23 is of an inversely placed structure.

In another alternative implementation, as shown in FIG. 3, the channel type of the first driving transistor DT1 is an N type, and the channel type of the second driving transistor DT2 is a P type. In such a case, the voltage signal inputted by the first power-supply terminal 25 is the low-level signal VSS, and the voltage signal inputted by the second power-supply terminal 26 is the high-level signal VDD. In the present implementation, the first electrode of the first light emitting device 22 is a cathode, the second electrode of the first light emitting device 22 is an anode, the first electrode of the second light emitting device 23 is an anode, and the second electrode of the second light emitting device 23 is a cathode.

In the present embodiment, the circuit structures of the first driving circuit 21 and the second driving circuit 24 are the same or different, which is not limited in the present embodiment. The first driving circuit 21 is any pixel driving circuit that is capable of driving the first light emitting device 22 to emit light, and the second driving circuit 24 is any pixel driving circuit that is capable of driving the second light emitting device 23 to emit light. The circuit structures of the first driving circuit 21 and the second driving circuit 24 are not limited in the present embodiment.

The first light emitting device 22 is an organic light emitting diode device, a quantum-dot light emitting diode device and so on, which is not limited in the present embodiment.

The second light emitting device 23 is an organic light emitting diode device, a quantum-dot light emitting diode device and so on, which is not limited in the present embodiment.

The colors of the emitted lights of the first light emitting device 22 and the second light emitting device 23 are the same or different, which is not limited in the present embodiment.

On the condition that the first light emitting device 22 and the second light emitting device 23 reach the equal brightness, as compared with the related art, the series-connected structure according to the present embodiment performs voltage division to the voltage between the first power-supply terminal 25 and the second power-supply terminal 26, to reduce the voltage at the two ends of the first driving circuit 21 and the first light emitting device 22, or reduce the voltage at the two ends of the second light emitting device 23 and the second driving circuit 24, which reduces the power consumption.

Regarding the first driving transistor DT1, what decides its electric current is the source electrode voltage and the grid electrode voltage of the first driving transistor DT1. Because the source electrode of the first driving transistor DT1 is connected to the first power-supply terminal 25, the source electrode voltage of the first driving transistor DT1 is exactly the voltage inputted by the first power-supply terminal 25, and the electric current in the first driving transistor DT1 is unrelated to the voltage of the first light emitting device 22 or the second light emitting device 23; in other words, the electric current in the first light emitting device 22 is unrelated to the emitted-light brightness of the first light emitting device 22 or the second light emitting device 23.

Regarding the second driving transistor DT2, what decides its electric current is the source electrode voltage and the grid electrode voltage of the second driving transistor DT2. Because the source electrode of the second driving transistor DT2 is connected to the second power-supply terminal 26, the source electrode voltage of the second driving transistor DT2 is exactly the voltage inputted by the second power-supply terminal 26, and the electric current in the second driving transistor DT2 is unrelated to the voltage of the first light emitting device 22 or the second light emitting device 23; in other words, the electric current in the second light emitting device 23 is unrelated to the emitted-light brightness of the first light emitting device 22 or the second light emitting device 23.

In the present embodiment, because the channel types of the first driving transistor DT1 and the second driving transistor DT2 are different, it is realized that the source electrode of the first driving transistor DT1 is connected to the first power-supply terminal 25, and the source electrode of the second driving transistor DT2 is connected to the second power-supply terminal 26. If the channel types of the first driving transistor DT1 and the second driving transistor DT2 are the same, then the electric current of one of the driving transistors is definitely influenced by the voltage of the first light emitting device 22 or the voltage of the second light emitting device 23, which results in instability of the driving current.

The pixel circuit according to the present embodiment, by connecting in series the first driving circuit, the first light emitting device, the second light emitting device and the second driving circuit between the first power-supply terminal and the second power-supply terminal, performs voltage division to the voltage between the first power-supply terminal and the second power-supply terminal, which, in an aspect, prevents increase of the heating quantity caused by an excessive voltage, and, in another aspect, on the condition that the first light emitting device and the second light emitting device reach the equal brightness realizes the effect of power-consumption reduction. In addition, because the channel types of the first driving transistor and the second driving transistor are different, the source electrode of the first driving transistor is connected to the first power-supply terminal, and the source electrode of the second driving transistor is connected to the second power-supply terminal, the electric current in the first light emitting device is unrelated to the emitted-light brightness of the first light emitting device or the second light emitting device, and the electric current in the second light emitting device is unrelated to the emitted-light brightness of the first light emitting device or the second light emitting device, which improves the stability of the driving current.

In a particular implementation, one of the first light emitting device 22 and the second light emitting device 23 is a light emitting device that is capable of emitting a blue light, and the other is a light emitting device that is capable of emitting a green light or a red light. That enables the first light emitting device 22 and the second light emitting device 23 to complement in terms of the driving voltages, to prevent increase of the heating quantity caused by an excessive voltage in the red-light device or the green-light device, thereby solving the problem of the conventional connecting mode that, because the cut-in voltage of the blue-light device is high, and in order to ensure the normal driving of the blue-light device, the green-light device and the red-light device connected in parallel to the blue-light device have an excessive voltage.

In the actual driving process, in order to ensure the stability of the pixel circuit, the mutually series-connected first light emitting device 22 and second light emitting device 23 may be controlled to synchronously emit light.

In order to independently control the brightness of the first light emitting device 22 and the second light emitting device 23, to prevent mutual interference between them, in an alternative implementation, referring to FIGs. 2 and 3, the pixel circuit may further include:
a bleeder component 27, connected to a first node A, wherein the first node A is connected to the second electrode of the first light emitting device 22 and the second electrode of the second light emitting device 23, so that the difference between the electric current in the first light emitting device 22 and the electric current in the second light emitting device 23 is equal to the electric current in the bleeder component 27.

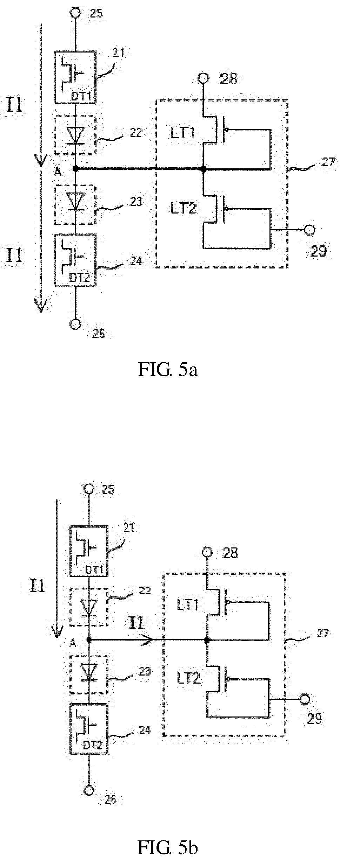

When the electric current in the first light emitting device 22 and the electric current in the second light emitting device 23 are not equal, the bleeder component 27 may serve for electric-current shunting. Referring to FIG. 5a, FIG. 5a shows a schematic diagram of the electric-current flowing direction when the electric current in the first light emitting device 22 and the electric current in the second light emitting device 23 are equal. As shown in FIG. 5a, both of the electric current in the first light emitting device 22 and the electric current in the second light emitting device 23 are I1. Referring to FIG. 5b, FIG. 5b shows a schematic diagram of the electric-current flowing direction when the electric current in the first light emitting device 22 and the electric current in the second light emitting device 23 are not equal. As shown in FIG. 5b, the electric current in the first light emitting device 22 is I1, the electric current in the second light emitting device 23 is zero, and the electric current I1 in the second light emitting device 23 flows out via the bleeder component 27.

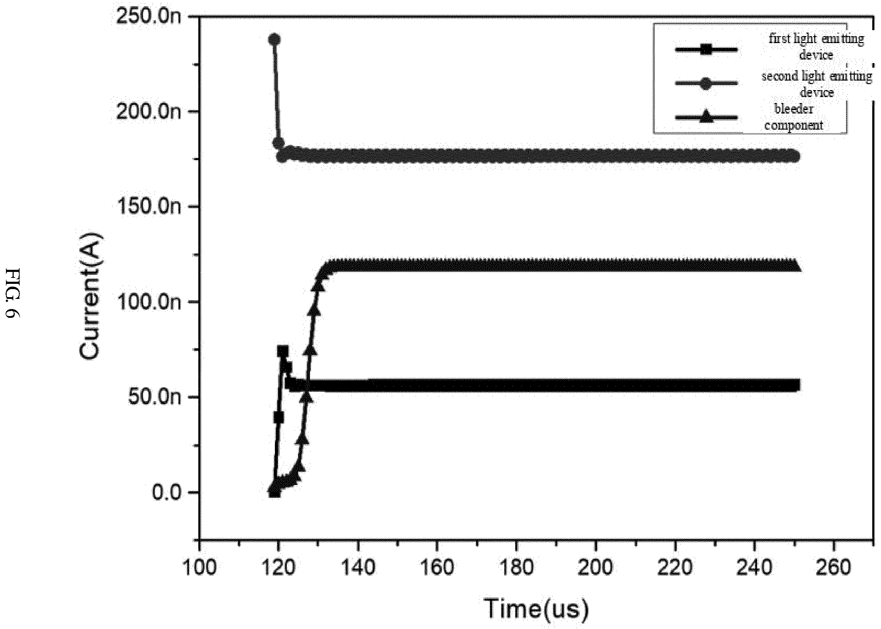

Referring to FIG. 6, FIG. 6 shows a simulating data diagram of the electric currents in the first light emitting device 22, the second light emitting device 23 and the bleeder component 27. As shown in FIG. 6, the difference between the electric current in the first light emitting device 22 and the electric current in the second light emitting device 23 is equal to the electric current in the bleeder component 27.

In the present implementation, the bleeder component 27 serves for electric-current shunting, and may have multiple particular structures. In an alternative implementation, referring to FIG. 2 or 3, the bleeder component 27 may include a first transistor LT1 and a second transistor LT2 that have the same channel type. A first electrode of the first transistor LT1 is connected to a first voltage inputting terminal 28, and a second electrode of the first transistor LT1 and the grid electrode of the first transistor LT1 are connected to the first node A. A first electrode of the second transistor LT2 is connected to the first node A, and a second electrode of the second transistor LT2 and the grid electrode of the second transistor LT2 are connected to a second voltage inputting terminal 29.

The voltages inputted by the first voltage inputting terminal 28 and the second voltage inputting terminal 29 may be equal; for example, both of them may be a constant voltage VLE.

Both of the first transistor LT1 and the second transistor LT2 are diode-connected.

Both of the channel types of the first transistor LT1 and the second transistor LT2 may be a P type, as shown in FIGs. 2 and 3, and both may also be an N-type, which is not limited in the present embodiment.

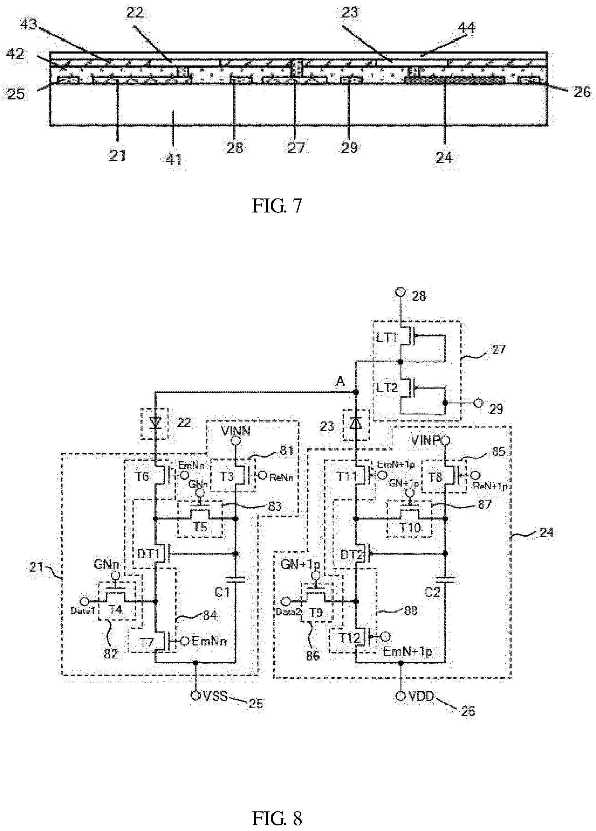

Referring to FIG. 7, FIG. 7 schematically shows a schematic sectional structural diagram of a pixel circuit having a bleeder component. As shown in FIG. 7, the bleeder component 27 may be disposed between the substrate 41 and the electrode layer 44, and the bleeder component 27 may be connected to the electrode layer 44 by a via hole.

As shown in FIGs. 2 and 3, when the difference between the electric current in the first light emitting device 22 and the electric current in the second light emitting device 23 is high, the voltage of the first node A increases or decreases, and the voltage difference at the two ends of the first transistor LT1 or the second transistor LT2 increases, whereby the first transistor LT1 or the second transistor LT2 is conducted, and completes the current balance together with the first driving transistor DT1 and the second driving transistor DT2, whereby finally the difference between the electric currents flowing through the first driving transistor DT1 and the second driving transistor DT2 is equal to the electric current in the first transistor LT1 or the electric current in the second transistor LT2, to enable the entire pixel circuit to reach the state of current balance.

Referring to FIG. 8, FIG. 8 schematically shows a particular schematic structural diagram of a pixel circuit. As shown in FIG. 8, the first driving circuit 21 may further include: a first capacitor C1, wherein a first electrode of the first capacitor C1 is connected to the first power-supply terminal 25, and a second electrode of the first capacitor C1 is connected to the grid electrode of the first driving transistor DT1.

As shown in FIG. 8, the first driving circuit 21 may further include: a first resetting module 81 configured for, according to a signal inputted by a first resetting controlling terminal ReNn, at a first resetting stage, transmitting a signal of a first initialized-voltage terminal VINN to the grid electrode of the first driving transistor DT1 and the second electrode of the first capacitor C1.

As shown in FIG. 8, the first driving circuit 21 may further include: a first writing module 82 configured for, according to a signal inputted by a first scanning-signal terminal GNn, at a first writing stage, writing a data signal of a first data writing terminal Data1 into the source electrode of the first driving transistor DT1.

As shown in FIG. 8, the first driving circuit 21 may further include: a first compensating module 83 configured for, according to a signal inputted by a first scanning-signal terminal GNn, at the first writing stage, conducting the drain electrode of the first driving transistor DT1 with the grid electrode of the first driving transistor DT1.

As shown in FIG. 8, the first driving circuit 21 may further include: a first light-emission controlling module 84 configured for, according to a signal inputted by a first light-emission controlling terminal EmNn, at the first resetting stage and the first writing stage, disconnecting the source electrode of the first driving transistor DT1 from the first power-supply terminal 25, and disconnecting the drain electrode of the first driving transistor DT1 from the first electrode of the first light emitting device 22, and, at a light-emission stage, conducting the source electrode of the first driving transistor DT1 with the first power-supply terminal 25, and conducting the drain electrode of the first driving transistor DT1 with the first electrode of the first light emitting device 22.

As shown in FIG. 8, the second driving circuit 24 may further include: a second capacitor C2, wherein a first electrode of the second capacitor C2 is connected to the second power-supply terminal 26, and a second electrode of the second capacitor C2 is connected to the grid electrode of the second driving transistor DT2.

As shown in FIG. 8, the second driving circuit 24 may further include: a second resetting module 85 configured for, according to a signal inputted by a second resetting controlling terminal ReN+1p, at a second resetting stage, transmitting a signal of a second initialized-voltage terminal VINP to the grid electrode of the second driving transistor DT2 and the second electrode of the second capacitor C2.

As shown in FIG. 8, the second driving circuit 24 may further include: a second writing module 86 configured for, according to a signal inputted by a second scanning-signal terminal GN+1p, at a second writing stage, writing a data signal of a second data writing terminal Data2 into the source electrode of the second driving transistor DT2.

As shown in FIG. 8, the second driving circuit 24 may further include: a second compensating module 87 configured for, according to a signal inputted by a second scanning-signal terminal GN+1p, at the second writing stage, conducting the drain electrode of the second driving transistor DT2 with the grid electrode of the second driving transistor DT2.

As shown in FIG. 8, the second driving circuit 24 may further include: a second light-emission controlling module 88 configured for, according to a signal inputted by a second light-emission controlling terminal EmN+1p, at the second resetting stage and the second writing stage, disconnecting the source electrode of the second driving transistor DT2 from the second power-supply terminal 26, and disconnecting the drain electrode of the second driving transistor DT2 from the first electrode of the second light emitting device 23, and, at the light-emission stage, conducting the source electrode of the second driving transistor DT2 with the second power-supply terminal 26, and conducting the drain electrode of the second driving transistor DT2 with the first electrode of the second light emitting device 23.

In the present implementation, the circuit structures of the first driving circuit 21 and the second driving circuit 24 are the same.

As shown in FIG. 8, the voltage signal inputted by the first power-supply terminal 25 may be the low-level signal VSS, the voltage signal inputted by the second power-supply terminal 26 may be the high-level signal VDD, the channel type of the first driving transistor DT1 is an N type, the channel type of the second driving transistor DT2 is a P type, the first electrode of the first light emitting device 22 is a cathode, the second electrode of the first light emitting device 22 is an anode, the first electrode of the second light emitting device 23 is an anode, and the second electrode of the second light emitting device 23 is a cathode.

As shown in FIG. 8, the first resetting module 81 may include a third transistor T3, the grid electrode of the third transistor T3 is connected to the first resetting controlling terminal ReNn, a first electrode of the third transistor T3 is connected to the first initialized-voltage terminal VINN, and a second electrode of the third transistor T3 is connected to the grid electrode of the first driving transistor DT1 and a second electrode of the first capacitor C1.

The first writing module 82 may include a fourth transistor T4, the grid electrode of the fourth transistor T4 is connected to the first scanning-signal terminal GNn, a first electrode of the fourth transistor T4 is connected to the first data writing terminal Data1, and a second electrode of the fourth transistor T4 is connected to the source electrode of the first driving transistor DT1.

The first compensating module 83 may include a fifth transistor T5, the grid electrode of the fifth transistor T5 is connected to the first scanning-signal terminal GNn, a first electrode of the fifth transistor T5 is connected to the grid electrode of the first driving transistor DT1, and a second electrode of the fifth transistor T5 is connected to the drain electrode of the first driving transistor DT1.

The first light-emission controlling module 84 may include a sixth transistor T6 and a seventh transistor T7. The grid electrode of the sixth transistor T6 is connected to the first light-emission controlling terminal EmNn, a first electrode of the sixth transistor T6 is connected to the drain electrode of the first driving transistor DT1, and a second electrode of the sixth transistor T6 is connected to the first electrode of the first light emitting device 22. The grid electrode of the seventh transistor T7 is connected to the first light-emission controlling terminal EmNn, the first electrode of the seventh transistor T7 is connected to the source electrode of the first driving transistor DT1, and a second electrode of the seventh transistor T7 is connected to the first power-supply terminal 25.

The second resetting module 85 may include an eighth transistor T8, the grid electrode of the eighth transistor T8 is connected to the second resetting controlling terminal ReN+1p, a first electrode of the eighth transistor T8 is connected to the second initialized-voltage terminal VINP, and a second electrode of the eighth transistor T8 is connected to the grid electrode of the second driving transistor DT2 and the second electrode of the second capacitor C2.

The second writing module 86 may include a ninth transistor T9, the grid electrode of the ninth transistor T9 is connected to the second scanning-signal terminal GN+1p, a first electrode of the ninth transistor T9 is connected to the second data writing terminal Data2, and a second electrode of the ninth transistor T9 is connected to the source electrode of the second driving transistor DT2.

The second compensating module 87 may include a tenth transistor T10, the grid electrode of the tenth transistor T10 is connected to the second scanning-signal terminal GN+1p, a first electrode of the tenth transistor T10 is connected to the grid electrode of the second driving transistor DT2, and a second electrode of the tenth transistor T10 is connected to the drain electrode of the second driving transistor DT2.

The second light-emission controlling module 88 may include an eleventh transistor T11 and a twelfth transistor T12. The grid electrode of the eleventh transistor T11 is connected to the second light-emission controlling terminal EmN+1p, a first electrode of the eleventh transistor T11 is connected to the drain electrode of the second driving transistor DT2, and a second electrode of the eleventh transistor T11 is connected to a first electrode of the second light emitting device 23. The grid electrode of the seventh transistor T7 is connected to the second light-emission controlling terminal EmN+1p, the first electrode of the seventh transistor T7 is connected to the source electrode of the second driving transistor DT2, and the second electrode of the seventh transistor T7 is connected to the second power-supply terminal 26.

In a particular implementation, the channel types of the third transistor T3, the fourth transistor T4, the fifth transistor T5, the sixth transistor T6, the seventh transistor T7, the eighth transistor T8, the ninth transistor T9, the tenth transistor T10, the eleventh transistor T11 and the twelfth transistor T12 may be any one of an N-type or a P type. The present implementation takes the case as an example for the description in which the channel types of the third transistor T3, the fourth transistor T4, the fifth transistor T5, the sixth transistor T6 and the seventh transistor T7 are an N-type and the channel types of the eighth transistor T8, the ninth transistor T9, the tenth transistor T10, the eleventh transistor T11 and the twelfth transistor T12 are a P type, as shown in FIG. 8.

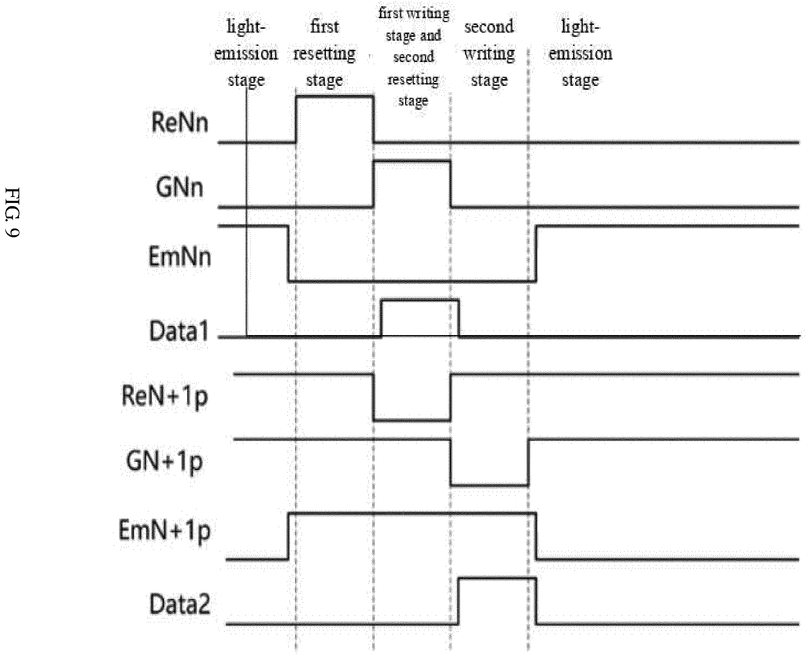

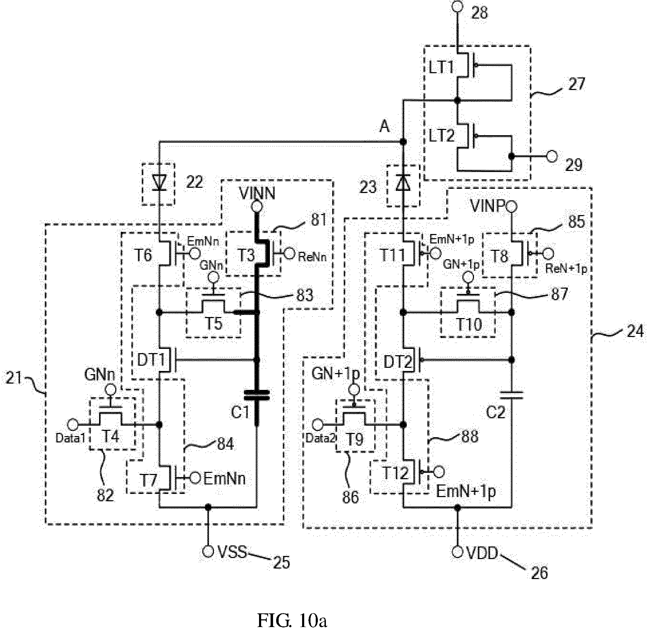

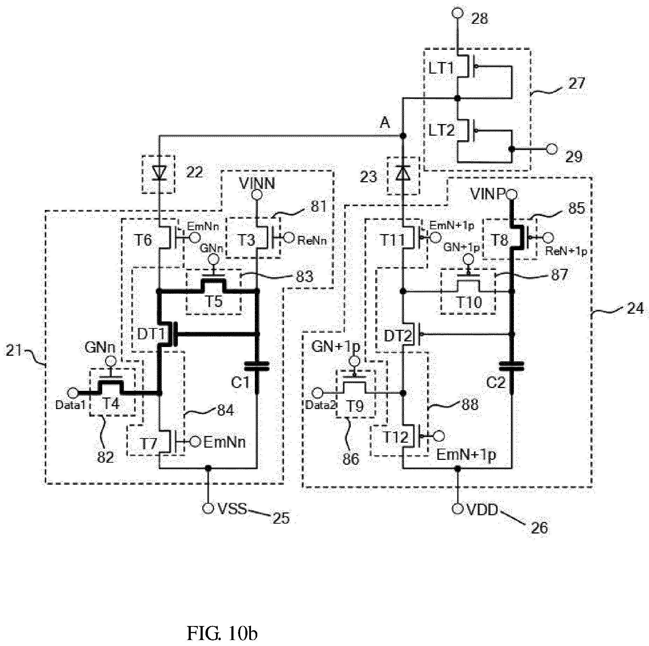

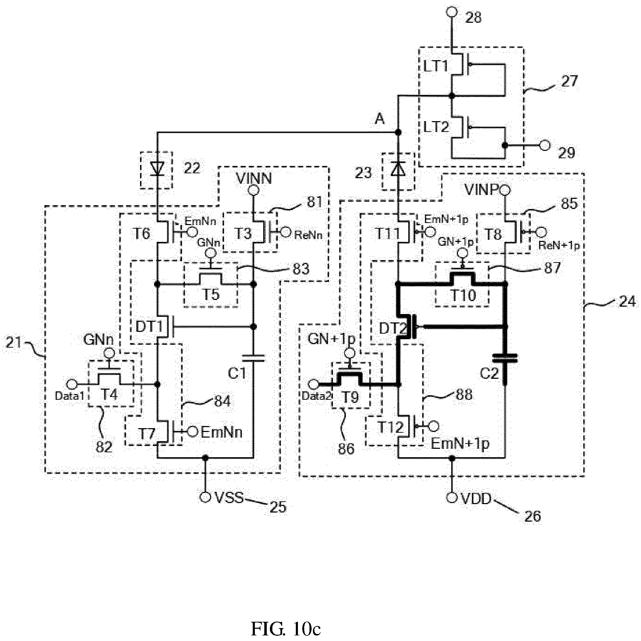

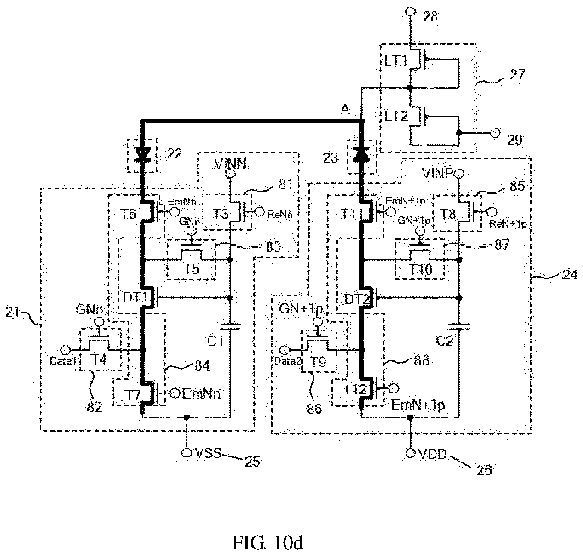

Assuming that, in FIG. 8, the first light emitting device 22 is located at the N-th row in the light emitting base plate, and the second light emitting device 23 is located at the (N+1)-th row in the light emitting base plate, referring to FIG. 9, FIG. 9 shows a sequence diagram of the signal inputting of the input terminals of the pixel circuit shown in FIG. 8. Referring to FIG. 10, FIG. 10 shows a schematic diagram of the electric-circuit conduction state of the stages shown in FIG. 9. The bolded lines and devices in FIG. 10 indicate that an electric current passes. The particular driving process may include:
at the first resetting stage, as shown in FIG. 10a, controlling the signal of the first initialized-voltage terminal VINN to be transmitted to the grid electrode of the first driving transistor DT1 and the second electrode of the first capacitor C1, controlling the source electrode of the first driving transistor DT1 to be disconnected from the first power-supply terminal 25, and controlling the drain electrode of the first driving transistor DT1 to be disconnected from the first electrode of the first light emitting device 22;
at the first writing stage, as shown in FIG. 10b, controlling the data signal of the first data writing terminal Data1 to be written into the source electrode of the first driving transistor DT1, controlling the drain electrode of the first driving transistor DT1 to be conducted with the grid electrode of the first driving transistor DT1, controlling the source electrode of the first driving transistor DT1 to be disconnected from the first power-supply terminal 25, and controlling the drain electrode of the first driving transistor DT1 to be disconnected from the first electrode of the first light emitting device 22;
at the second resetting stage, as shown in FIG. 10b, controlling the signal of the second initialized-voltage terminal VINP to be transmitted to the grid electrode of the second driving transistor DT2 and the second electrode of the second capacitor C2, controlling the source electrode of the second driving transistor DT2 to be disconnected from the second power-supply terminal 26, and controlling the drain electrode of the second driving transistor DT2 to be disconnected from the first electrode of the second light emitting device 23;
at the second writing stage, as shown in FIG. 10c, controlling the data signal of the second data writing terminal Data2 to be written into the source electrode of the second driving transistor DT2, controlling the drain electrode of the second driving transistor DT2 to be conducted with the grid electrode of the second driving transistor DT2, controlling the source electrode of the second driving transistor DT2 to be disconnected from the second power-supply terminal 26, and controlling the drain electrode of the second driving transistor DT2 to be disconnected from the first electrode of the second light emitting device 23; and
at the light-emission stage, as shown in FIG. 10d, controlling the source electrode of the first driving transistor DT1 to be conducted with the first power-supply terminal 25, controlling the drain electrode of the first driving transistor DT1 to be conducted with the first electrode of the first light emitting device 22, controlling the source electrode of the second driving transistor DT2 to be conducted with the second power-supply terminal 26, and controlling the drain electrode of the second driving transistor DT2 to be conducted with the first electrode of the second light emitting device 23. The first light emitting device 22 and the second light emitting device 23 synchronously emit light at the light-emission stage.

The second resetting stage and the first writing stage may proceed synchronously.

In order that the first light emitting device 22 and the second light emitting device 23 synchronously emit light at the light-emission stage, the signals inputted by the first light-emission controlling terminal EmNn and the second light-emission controlling terminal EmN+1p may be controlled to have the same width and switching time.

At the light-emission stage, the driving current *I₁* in the first light emitting device 22 is:
*I*₁ = *β* × (*Vdata*1 + *Vth*1 - *VSS* - *Vth*1)², wherein *Vdata1* is the data signal inputted by the first data writing terminal Data1, *Vth1* is the threshold voltage of the first driving transistor DT1, and *VSS* is the voltage inputted by the first power-supply terminal 25.

The driving current *I₂* in the second light emitting device 23 is:
*I₂ = β* × (*Vdata*2 + *Vth*2 *- VDD - Vth*2)², wherein *Vdata2* is the data signal inputted by the second data writing terminal Data2, *Vth2* is the threshold voltage of the second driving transistor DT2, and *VDD* is the voltage inputted by the second power-supply terminal 26.

In the driving process, the first light-emission controlling terminal EmNn and the second light-emission controlling terminal EmN+1p are required to shut off the first light-emission controlling module 84 and the second light-emission controlling module 88 before the first resetting controlling terminal ReNn and the second resetting controlling terminal ReN+1p input effective resetting signals, and turn on the first light-emission controlling module 84 and the second light-emission controlling module 88 after the scanning signals inputted by the first scanning-signal terminal GNn and the second scanning-signal terminal GN+1p are ineffective, as shown in FIG. 9.

The shutting off the first light-emission controlling module 84 refers to disconnecting the source electrode of the first driving transistor DT1 from the first power-supply terminal 25, and disconnecting the drain electrode of the first driving transistor DT1 from the first electrode of the first light emitting device 22. The turning on the first light-emission controlling module 84 refers to conducting the source electrode of the first driving transistor DT1 with the first power-supply terminal 25, and conducting the drain electrode of the first driving transistor DT1 with the first electrode of the first light emitting device 22.

The shutting off the second light-emission controlling module 88 refers to disconnecting the source electrode of the second driving transistor DT2 from the second power-supply terminal 26, and disconnecting the drain electrode of the second driving transistor DT2 from the first electrode of the second light emitting device 23. The turning on the second light-emission controlling module 88 refers to conducting the source electrode of the second driving transistor DT2 with the second power-supply terminal 26, and conducting the drain electrode of the second driving transistor DT2 with the first electrode of the second light emitting device 23.

An embodiment of the present disclosure provides a light emitting base plate, wherein the light emitting base plate includes the pixel circuit according to any one of the above embodiments.

In the present embodiment, the light emitting base plate is used for illumination, i.e., applied to an illuminating device, and is also used for displaying, i.e., applied to a light emitting device.

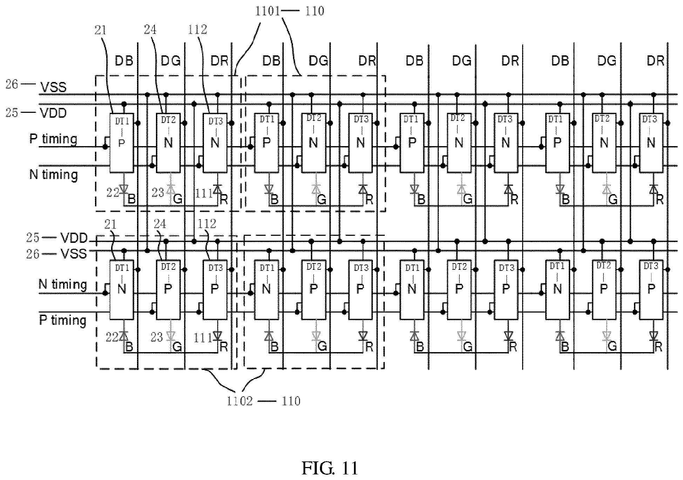

Referring to FIGs. 11 to 16, FIGs. 11 to 16 show schematic planar structural diagrams of several light emitting base plates. As shown in FIGs. 11 to 16, the light emitting base plate includes a plurality of pixel units 110. The plurality of pixel units 110 may be arranged in an array.

In an alternative implementation, as shown in FIGs. 11 to 13, the first light emitting device 22 and the second light emitting device 23 may be located in the same pixel unit 110. Particularly, one pixel unit 110 may include a plurality of sub-pixel units of different colors, for example a red-color sub-pixel unit R, a blue-color sub-pixel unit B and a green-color sub-pixel unit G, and the first light emitting device 22 and the second light emitting device 23 may be located at the sub-pixel units of different colors in the same pixel unit 110. In the present implementation, the first light emitting device 22 and the second light emitting device 23 may emit lights of different colors.

As shown in FIGs. 11 to 13, in the same one above-described pixel unit 110, the pixel circuit may further include a third light emitting device 111 and a third driving circuit 112.

In a particular implementation, the first light emitting device 22, the second light emitting device 23 and the third light emitting device 111 may be located at the sub-pixel units of different colors in the same pixel unit 110.

The third driving circuit 112 may include a third driving transistor DT3, the source electrode of the third driving transistor is connected to the second power-supply terminal 26, and the drain electrode of the third driving transistor DT3 is connected to a first electrode of the third light emitting device 111.

A second electrode of the third light emitting device 111 is connected to the second electrode of the first light emitting device 22 and the second electrode of the second light emitting device 23.

The channel type of the third driving transistor DT3 and the channel type of the second driving transistor DT2 are the same.

The third driving circuit 112 may have a circuit structure the same as or different from the circuit structures of the first driving circuit 21 and the second driving circuit 24, which is not limited in the present embodiment.

It should be noted that, in FIGs. 11 to 16, DT1-P represents that the channel type of the first driving transistor DT1 is a P type, DT1-N represents that the channel type of the first driving transistor DT1 is an N type, DT2-P represents that the channel type of the second driving transistor DT2 is a P type, DT2-N represents that the channel type of the second driving transistor DT2 is an N type, DT3-P represents that the channel type of the third driving transistor DT3 is a P type, and DT3-N represents that the channel type of the third driving transistor DT3 is an N type.

As shown in FIGs. 11 to 13, in a certain pixel unit 110, when the first driving transistor DT1 is of a P type, the third driving transistor DT3 and the second driving transistor DT2 are of an N type, and when the first driving transistor DT1 is of an N type, the third driving transistor DT3 and the second driving transistor DT2 are of a P type.

As shown in FIGs. 11 to 13, the first driving circuit 21 and the first light emitting device 22 form a first branch circuit, the second driving circuit 24 and the second light emitting device 23 form a second branch circuit, and the third driving circuit 112 and the third light emitting device 111 form a third branch circuit, wherein the second branch circuit and the first branch circuit are connected in series, and the second branch circuit and the third branch circuit are connected in parallel.

Because, in the process of normal driving, the driving current of the blue-light device is approximately equal to the sum of the driving currents of the green-light device and the red-light device, the first light emitting device 22 may be a light emitting device capable of emitting a blue light, the second light emitting device 23 may be a light emitting device capable of emitting a green light, and the third light emitting device 111 may be a light emitting device capable of emitting a red light. That can enable the total current in the driving transistors in the pixel circuit whose channel types are a P type to be close to the total current in the driving transistors whose channel types are an N type, which facilitates the controlling on the white balance, and can ensure the current balance in the displaying of the frames of the colors such as yellow, cyan, violet, green, red and blue.

As shown in FIGs. 11 to 13, taking the case as an example in which the channel type of the first driving transistor DT1 is a P type, and the channel types of the third driving transistor DT3 and the second driving transistor DT2 are an N type, the driving voltage corresponding to one pixel unit 110 is:
$VDD - VSS = {VTFT}_{p} + {VTFT}_{n} + {VQLED}_{R} + {VQLED}_{B} ,$
wherein *VTFTₚ* is the voltage of the first driving transistor DT1 of the P type, *VTFTₙ* is the voltage of the second driving transistor DT2 of the N type, *VQLED_{R}* is the voltage of the second light emitting device 23 (the red-light device), and *VQLED_{B}* is the voltage of the first light emitting device 22 (the blue-light device). It should be noted that the above driving voltages have neglected the voltages of the switching transistors other than the driving transistors in the driving circuit.

The power consumption corresponding to the pixel unit 110 is:
$P 1 = {I}_{BOLED} \times \left(VDD-VSS\right) = {I}_{BOLED} \times \left({VTFT}_{p}+{VTFT}_{n}+{VQLED}_{R}+{VQLED}_{B}\right) ,$
wherein *I_{BOLED}* is the electric current of the first light emitting device 22 (the blue-light device).

As a comparison, in the related art, the power consumption of one pixel unit as shown in FIG. 1 is:
$P 2 = \left({I}_{BOLED}+{I}_{GOLED}+{I}_{ROLED}\right) \times \left({VTFT}_{p}+{VQLED}_{B}\right) ,$ wherein *I_{BOLED}* is the electric current of the blue-light device, *I_{GOLED}* is the electric current of the green-light device, *I_{ROLED}* is the electric current of the red-light device, *VTFTₚ* is the voltage of the pixel driving circuit 11 in FIG. 1, and *VQLED_{B}* is the voltage of the light emitting device 12 in FIG. 1.

Generally, *VTFTₚ* is approximately equal to *VTFTₙ, I_{BOLED}* is approximately equal to *I_{GOLED}* + *I_{ROLED}*, and it is calculated that P2-P1=2**VQLED_{B}*-(*VQLED_{R}* + *VQLED_{B}*). because the voltage of the blue-light device is greater than the voltage of the red-light device, i.e., *VQLED_{B}* > *VQLED_{R},* the power consumption P2 of one pixel unit shown in FIG. 1 is greater than the power consumption P1 of one pixel unit shown in FIGs. 11 to 13. Therefore, the pixel circuit according to the present disclosure can reduce the power consumption.

In addition, because both of the first power-supply terminal 25 and the second power-supply terminal 26 are a metal trace, and the pixel circuit according to the present disclosure can reduce the power consumption, the electric currents in those metal traces are reduced, whereby the voltage drops on the metal traces are reduced, thereby facilitating to improve the brightness uniformity of the light emitting base plate.

In a type of the light emitting base plate, the plurality of pixel units 110 may include a first pixel unit 1101. The first pixel unit 1101, as shown in FIGs. 11 to 13, includes a first light emitting device 22, a second light emitting device 23 and a third light emitting device 111. In the first pixel unit 1101, the channel type of the first driving transistor DT1 is a P type, the channel type of the second driving transistor DT2 and the channel type of the third driving transistor DT3 are an N type, the first electrode of the first light emitting device 22 is an anode, the first electrode of the second light emitting device 23 and the first electrode of the third light emitting device 111 are a cathode, and the voltage inputted by the first power-supply terminal 25 is greater than the voltage inputted by the second power-supply terminal 26. The second electrode of the first light emitting device 22 is a cathode, and the second electrode of the second light emitting device 23 and the second electrode of the third light emitting device 111 are an anode. The voltage signal inputted by the first power-supply terminal 25 may be the high-level signal VDD, and the voltage signal inputted by the second power-supply terminal 26 may be the low-level signal VSS. Optionally, the pixel units 110 of the light emitting base plate are the first pixel unit 1101.

In another type of the light emitting base plate, the plurality of pixel units 110 may include a second pixel unit 1102. The second pixel unit 1102, as shown in FIGs. 11 to 13, includes a first light emitting device 22, a second light emitting device 23 and a third light emitting device 111. In the second pixel unit 1102, the channel type of the first driving transistor DT1 is an N type, the channel type of the second driving transistor DT2 and the channel type of the third driving transistor DT3 are a P type, the first electrode of the first light emitting device 22 is a cathode, the first electrode of the second light emitting device 23 and the first electrode of the third light emitting device 111 are an anode, and the voltage inputted by the first power-supply terminal 25 is less than the voltage inputted by the second power-supply terminal 26. The second electrode of the first light emitting device 22 is an anode, and the second electrodes of the second light emitting device 23 and the third light emitting device 111 are a cathode. The voltage signal inputted by the first power-supply terminal 25 may be the low-level signal VSS, and the voltage signal inputted by the second power-supply terminal 26 may be the high-level signal VDD. Optionally, the pixel units 110 of the light emitting base plate are the second pixel unit 1102.

In yet another type of the light emitting base plate, referring to FIGs. 11 to 13, the plurality of pixel units 110 may include the first pixel unit 1101 stated above and the second pixel unit 1102 stated above, as shown in FIGs. 11 to 13.

When the plurality of pixel units 110 include the first pixel unit 1101 and the second pixel unit 1102, the first pixel unit 1101 and the second pixel unit 1102 may be located at different scanning lines of two neighboring scanning lines, as shown in FIG. 11.

For example, when the first pixel unit 1101 is located at a first scanning line, the second pixel unit 1102 is located at a neighboring second scanning line of the first scanning line. At least one of the pixel units in the first scanning line is the first pixel unit 1101, and at least one of the pixel units in the second scanning line is the second pixel unit 1102. Optionally, the pixel units in the first scanning line are the first pixel unit 1101, and the pixel units in the second scanning line are the second pixel unit 1102, as shown in FIG. 11.

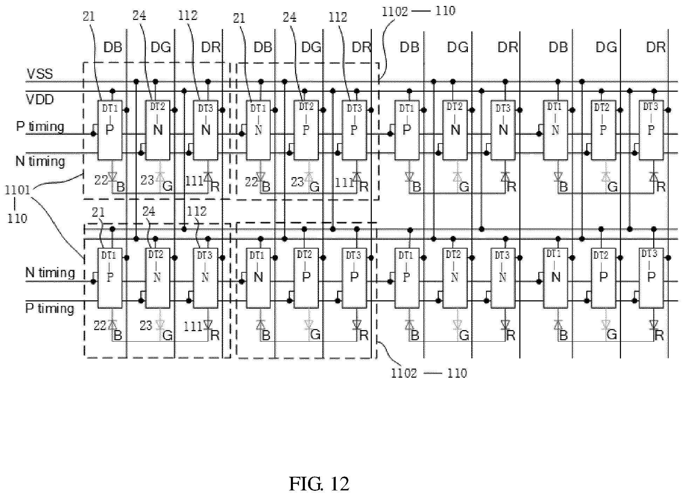

When the plurality of pixel units 110 include the first pixel unit 1101 and the second pixel unit 1102, the first pixel unit 1101 and the second pixel unit 1102 are located at different data columns of two neighboring data columns, as shown in FIG. 12.

For example, when the first pixel unit 1101 is located at a first data column, the second pixel unit 1102 is located at a neighboring second data column of the first data column. At least one of the pixel units in the first data column is the first pixel unit 1101, and at least one of the pixel units in the second data column is the second pixel unit 1102. Optionally, the pixel units in the first data column are the first pixel unit 1101, and the pixel units in the second data column are the second pixel unit 1102, as shown in FIG. 12.

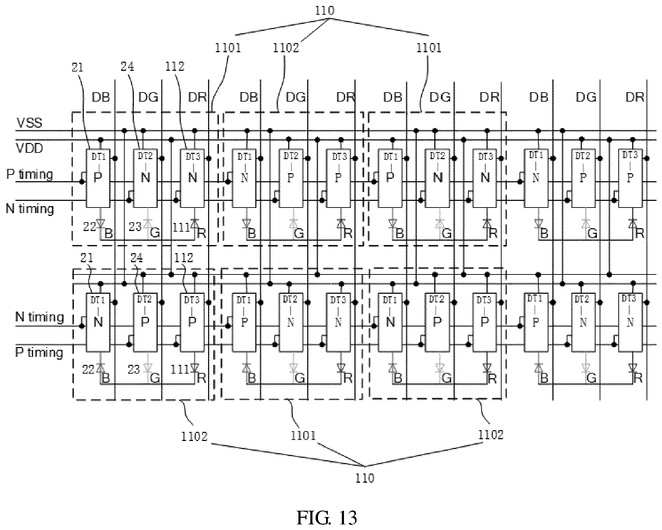

When the plurality of pixel units 110 include the first pixel unit 1101 and the second pixel unit 1102, at least one of the neighboring pixel units 110 of the first pixel unit 1101 is the second pixel unit 1102, and at least one of the neighboring pixel units 110 of the second pixel unit 1102 is the first pixel unit 1101, as shown in FIG. 13.

Optionally, the neighboring pixel units 110 of the first pixel unit 1101 may be the second pixel unit 1102, and the neighboring pixel units 110 of the second pixel unit 1102 may be the first pixel unit 1101, as shown in FIG. 13.

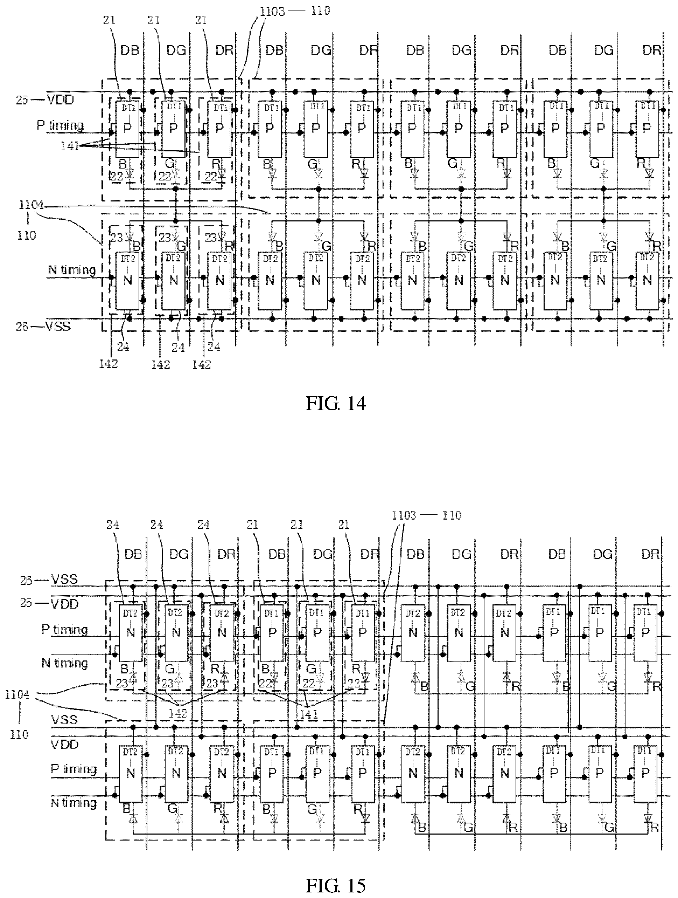

In another alternative implementation, as shown in FIGs. 14 to 16, the first light emitting device 22 and the second light emitting device 23 may be located in different pixel units 110. If the plurality of pixel units 110 include a third pixel unit 1103 and a fourth pixel unit 1104, then the first light emitting device 22 is located in the third pixel unit 1103, and the second light emitting device 23 is located in the fourth pixel unit 1104. The third pixel unit 1103 and the fourth pixel unit 1104 are different pixel units.

Optionally, the third pixel unit 1103 includes one or more first sub-pixel units 141, each of the first sub-pixel units 141 is provided with one first light emitting device 22 and one first driving circuit 21, and the first light emitting devices 22 in different first sub-pixel units 141 are different.

The fourth pixel unit 1104 includes one or more second sub-pixel units 142, each of the second sub-pixel units 142 is provided with one second light emitting device 23 and one second driving circuit 24, and the second light emitting devices 23 in different second sub-pixel units 142 are different.

The second electrode of any one of the first light emitting devices 22 of the third pixel units 1103 is connected to the second electrodes of the second light emitting devices 23 of the fourth pixel units 1104.

Particularly, one pixel unit 110 may include a plurality of sub-pixel units of different colors, for example a red-color sub-pixel unit R, a blue-color sub-pixel unit B and a green-color sub-pixel unit G. As shown in FIGs. 14 to 16, the first sub-pixel unit 141 is a sub-pixel unit in the third pixel unit 1103, and the second sub-pixel unit 142 is a sub-pixel unit in the fourth pixel unit 1104.

As shown in FIGs. 14 to 16, the third pixel unit 1103 includes three first sub-pixel units 141, wherein the first light emitting device 22 in one of the first sub-pixel units 141 can emit a red light, the first light emitting device 22 in one of the first sub-pixel units 141 can emit a green light, and the first light emitting device 22 in one of the first sub-pixel units 141 can emit a blue light.

As shown in FIGs. 14 to 16, the fourth pixel unit 1104 includes three second sub-pixel units 142, wherein the second light emitting device 23 in one of the second sub-pixel units 142 can emit a red light, the second light emitting device 23 in one of the second sub-pixel units 142 can emit a green light, and the second light emitting device 23 in one of the second sub-pixel units 142 can emit a blue light.

As shown in FIGs. 14 to 16, one first light emitting device 22 and one first driving circuit 21 in the first sub-pixel unit 141 form a first branch circuit, one second light emitting device 23 and one second driving circuit 24 in the second sub-pixel unit 142 form a second branch circuit, the three first branch circuits in the third pixel unit 1103 are connected in parallel, the three second branch circuits in the fourth pixel unit 1104 are connected in parallel, and the three parallel-connected first branch circuits and the three parallel-connected second branch circuits are connected in series.

The third pixel unit 1103 and the fourth pixel unit 1104 may be two neighboring pixel units 110. Optionally, the third pixel unit 1103 and the fourth pixel unit 1104 may be located at different scanning lines of two neighboring scanning lines, as shown in FIG. 14.

For example, when the third pixel unit 1103 is located at a third scanning line, the fourth pixel unit 1104 is located at a neighboring fourth scanning line of the third scanning line. At least one of the pixel units in the third scanning line is the third pixel unit 1103, and at least one of the pixel units in the fourth scanning line is the fourth pixel unit 1104. Optionally, the pixel units in the third scanning line are the third pixel units 1103, and the pixel units in the fourth scanning line are the fourth pixel units 1104, as shown in FIG. 14.

The third pixel unit 1103 and the fourth pixel unit 1104 may be two neighboring pixel units 110. Optionally, the third pixel unit 1103 and the fourth pixel unit 1104 may be located at different data columns of two neighboring data columns, as shown in FIG. 15.

For example, when the third pixel unit 1103 is located at a third data column, the fourth pixel unit 1104 is located at a neighboring fourth data column of the third data column. At least one of the pixel units in the third data column is the third pixel unit 1103, and at least one of the pixel units in the fourth data column is the fourth pixel unit 1104. Optionally, the pixel units in the third data column are the third pixel units 1103, and the pixel units in the fourth data column are the fourth pixel units 1104, as shown in FIG. 15.

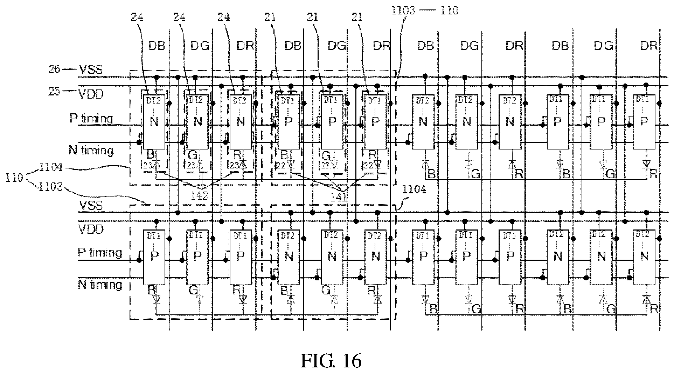

That the third pixel unit 1103 and the fourth pixel unit 1104 may be two neighboring pixel units 110 refers to that at least one of the neighboring pixel units 110 of the third pixel unit 1103 is the fourth pixel unit 1104, and at least one of the neighboring pixel units 110 of the fourth pixel unit 1104 is the third pixel unit 1103. Optionally, the neighboring pixel units 110 of the third pixel unit 1103 are the fourth pixel unit 1104, and the neighboring pixel units 110 of the fourth pixel unit 1104 are the third pixel unit 1103, as shown in FIG. 16.

In a particular implementation, as shown in FIGs. 14 to 16, the channel types of the first driving transistors DT1 in the third pixel units 1103 may be a P type, the first electrodes of the first light emitting devices 22 are an anode, and the second electrodes of the first light emitting devices 22 are a cathode. The channel types of the second driving transistors DT2 in the fourth pixel units 1104 may be an N type, the first electrodes of the second light emitting devices 23 are a cathode, and the second electrodes of the second light emitting devices 23 are an anode. The voltage inputted by the first power-supply terminal 25 is greater than the voltage inputted by the second power-supply terminal 26. For example, the voltage signal inputted by the first power-supply terminal 25 may be the high-level signal VDD, and the voltage signal inputted by the second power-supply terminal 26 may be the low-level signal VSS.

Alternatively, the channel types of the first driving transistors DT1 in the third pixel units 1103 may be an N type, the first electrodes of the first light emitting devices 22 are a cathode, and the second electrodes of the first light emitting devices 22 are an anode. The channel types of the second driving transistors DT2 in the fourth pixel units 1104 may be a P type, the first electrodes of the second light emitting devices 23 are an anode, and the second electrodes of the second light emitting devices 23 are a cathode. The voltage inputted by the first power-supply terminal 25 is less than the voltage inputted by the second power-supply terminal 26. For example, the voltage signal inputted by the first power-supply terminal 25 may be the low-level signal VSS, and the voltage signal inputted by the second power-supply terminal 26 may be the high-level signal VDD.

FIGs. 14 to 16 show a structure in which one third pixel unit 1103 and one fourth pixel unit 1104 are connected. In other words, the first sub-pixel units in the one third pixel unit 1103 are connected in parallel, the second sub-pixel units in the one fourth pixel unit 1104 are connected in parallel, and subsequently the parallel-connected first sub-pixel units and the parallel-connected second sub-pixel units are connected in series.

In a particular implementation, optionally, the first sub-pixel units in a plurality of third pixel units 1103 (for example, 2*2, 3*3 or 2*3 and so on) are connected in parallel, the second sub-pixel units in a plurality of fourth pixel units 1104 (for example, 2*2, 3*3 or 2*3 and so on) are connected in parallel, and subsequently the parallel-connected first sub-pixel units and the parallel-connected second sub-pixel units are connected in series.

Another embodiment of the present disclosure further provides a light emitting apparatus, wherein the light emitting apparatus includes the light emitting base plate according to any one of the above embodiments.

In some embodiments, the light emitting apparatus is an illuminating device. In this case, the light emitting apparatus serves as a light source, to realize the function of illumination. In an embodiment, the light emitting apparatus is a backlight module in a liquid-crystal displaying device, or be used for a lamp for internal illumination or external illumination, or various signal lamps.

In some other embodiments, the light emitting apparatus is a displaying device. In this case, the light emitting base plate is a displaying base plate, and is used to realize the function of displaying images (i.e., frames). The light emitting apparatus includes a display or a product including a display. The display is a Flat Panel Display (FPD), a micro-display and so on. If classified based on whether the user sees the scene at the back face of the display, the display is a transparent display or a non-transparent display. If classified based on whether the display is capable of being bent or curled, the display is a flexible display or a common display (which may be referred to as a rigid display). As an example, the product including a display includes: a computer display, a television set, a billboard, a laser printer having the function of displaying, a telephone, a mobile phone, a Personal Digital Assistant (PDA), a laptop computer, a digital camera, a portable camcorder, a viewfinder, a vehicle, a large-area wall, a theater screen, a stadium scutcheon and so on.

Another embodiment of the present disclosure further provides a driving method of a pixel circuit, wherein the method is for driving the pixel circuit according to any one of the above embodiments, and the driving method includes:
at the light-emission stage, controlling the first light emitting device and the second light emitting device to synchronously emit light.

As shown in FIG. 8, when the first driving circuit includes the first capacitor C1, the first resetting module 81, the first writing module 82, the first compensating module 83 and the first light-emission controlling module 84, and the second driving circuit includes the second capacitor C2, the second resetting module 85, the second writing module 86, the second compensating module 87 and the second light-emission controlling module 88, before the light-emission stage, the method may further include:
at the first resetting stage, controlling the signal of the first initialized-voltage terminal VINN to be transmitted to the grid electrode of the first driving transistor DT1 and the second electrode of the first capacitor C1, controlling the source electrode of the first driving transistor DT1 to be disconnected from the first power-supply terminal 25, and controlling the drain electrode of the first driving transistor DT1 to be disconnected from the first electrode of the first light emitting device 22;
at the first writing stage, controlling the data signal of the first data writing terminal Data1 to be written into the source electrode of the first driving transistor DT1, controlling the drain electrode of the first driving transistor DT1 to be conducted with the grid electrode of the first driving transistor DT1, controlling the source electrode of the first driving transistor DT1 to be disconnected from the first power-supply terminal 25, and controlling the drain electrode of the first driving transistor DT1 to be disconnected from the first electrode of the first light emitting device 22;
at the second resetting stage, controlling the signal of the second initialized-voltage terminal VINP to be transmitted to the grid electrode of the second driving transistor DT2 and the second electrode of the second capacitor C2, controlling the source electrode of the second driving transistor DT2 to be disconnected from the second power-supply terminal 26, and controlling the drain electrode of the second driving transistor DT2 to be disconnected from the first electrode of the second light emitting device 23;
at the second writing stage, controlling the data signal of the second data writing terminal Data2 to be written into the source electrode of the second driving transistor DT2, controlling the drain electrode of the second driving transistor DT2 to be conducted with the grid electrode of the second driving transistor DT2, controlling the source electrode of the second driving transistor DT2 to be disconnected from the second power-supply terminal 26, and controlling the drain electrode of the second driving transistor DT2 to be disconnected from the first electrode of the second light emitting device 23; and
at the light-emission stage, the method further includes: controlling the source electrode of the first driving transistor DT1 to be conducted with the first power-supply terminal 25, controlling the drain electrode of the first driving transistor DT1 to be conducted with the first electrode of the first light emitting device 22, controlling the source electrode of the second driving transistor DT2 to be conducted with the second power-supply terminal 26, and controlling the drain electrode of the second driving transistor DT2 to be conducted with the first electrode of the second light emitting device 23.
the second resetting stage and the first writing stage proceed synchronously.

The particular driving process has been described in detail in the embodiments of the pixel circuit, and is not discussed herein further.

The embodiments of the description are described in the mode of progression, each of the embodiments emphatically describes the differences from the other embodiments, and the same or similar parts of the embodiments may refer to each other.

Finally, it should also be noted that, in the present text, relation terms such as first and second are merely intended to distinguish one entity or operation from another entity or operation, and that does not necessarily require or imply that those entities or operations have therebetween any such actual relation or order. Furthermore, the terms "include", "comprise" or any variants thereof are intended to cover non-exclusive inclusions, so that processes, methods, articles or devices that include a series of elements do not only include those elements, but also include other elements that are not explicitly listed, or include the elements that are inherent to such processes, methods, articles or devices. Unless further limitation is set forth, an element defined by the wording "comprising a ..." does not exclude additional same element in the process, method, article or device comprising the element.

The pixel circuit, the pixel driving method, the light emitting base plate and the light emitting apparatus according to the present disclosure have been described in detail above. The principle and the embodiments of the present disclosure are described herein with reference to the particular examples, and the description of the above embodiments is merely intended to facilitate to understand the method according to the present disclosure and its core concept. Moreover, for a person skilled in the art, according to the concept of the present disclosure, the particular embodiments and the range of application may be varied. In conclusion, the contents of the description should not be understood as limiting the present disclosure.

A person skilled in the art, after considering the description and implementing the invention disclosed herein, will readily envisage other embodiments of the present disclosure. The description and the embodiments are merely deemed as exemplary, and the true scope of the present disclosure are presented by the following claims.

It should be understood that the present disclosure is not limited to the accurate structure that has been described above and shown in the drawings, and may have various modifications and variations without departing from its scope. The scope of the present disclosure is merely limited by the appended claims.

The "one embodiment", "an embodiment" or "one or more embodiments" as used herein means that particular features, structures or characteristics described with reference to an embodiment are included in at least one embodiment of the present disclosure. Moreover, it should be noted that here an example using the wording "in an embodiment" does not necessarily refer to the same one embodiment.

The description provided herein describes many concrete details. However, it can be understood that the embodiments of the present disclosure may be implemented without those concrete details. In some of the embodiments, well-known processes, structures and techniques are not described in detail, so as not to affect the understanding of the description.

In the claims, any reference signs between parentheses should not be construed as limiting the claims. The word "comprise" does not exclude elements or steps that are not listed in the claims. The word "a" or "an" preceding an element does not exclude the existing of a plurality of such elements. The present disclosure may be implemented by means of hardware comprising several different elements and by means of a properly programmed computer. In unit claims that list several devices, some of those devices may be embodied by the same item of hardware. The words first, second, third and so on do not denote any order. Those words may be interpreted as names.

## Claims

1. A pixel circuit, the pixel circuit comprising a first driving circuit (21), a first light emitting device (22), a second light emitting device (23) and a second driving circuit (24) that are sequentially connected in series;
the first driving circuit (21) comprising a first driving transistor (DT1), a source electrode of the first driving transistor (DT1) being connected to a first power-supply terminal (25), and a drain electrode of the first driving transistor (DT1) being connected to a first electrode of the first light emitting device (22);
the second driving circuit (24) comprising a second driving transistor (DT2),
**characterized in that** a source electrode of the second driving transistor (DT2) is connected to a second power-supply terminal (26), and a drain electrode of the second driving transistor (DT2) is connected to a first electrode of the second light emitting device (23);
a second electrode of the first light emitting device (22) is connected to a second electrode of the second light emitting device (23); and
a channel type of the first driving transistor (DT1) and a channel type of the second driving transistor (DT2) are different;
wherein one of the first light emitting device (22) and the second light emitting device (23) is a light emitting device capable of emitting a blue light, and the other is a light emitting device capable of emitting a green light or a red light.

2. The pixel circuit according to claim 1, wherein the channel type of the first driving transistor (DT1) is a P type, the channel type of the second driving transistor (DT2) is an N type, the first electrode of the first light emitting device (22) is an anode, the first electrode of the second light emitting device (23) is a cathode, and a voltage inputted by the first power-supply terminal (25) is greater than a voltage inputted by the second power-supply terminal (26); or
the channel type of the first driving transistor (DT1) is an N type, the channel type of the second driving transistor (DT2) is a P type, the first electrode of the first light emitting device (22) is a cathode, the first electrode of the second light emitting device (23) is an anode, and a voltage inputted by the first power-supply terminal (25) is less than a voltage inputted by the second power-supply terminal (26).

3. The pixel circuit according to claim 1, wherein the pixel circuit further comprises:
a bleeder component (27), connected to a first node (A), wherein the first node (A) is connected to the second electrode of the first light emitting device (22) and the second electrode of the second light emitting device (23), so that a difference between an electric current in the first light emitting device (22) and an electric current in the second light emitting device (23) is equal to an electric current in the bleeder component (27).

4. The pixel circuit according to claim 3, wherein the bleeder component (27) comprises a first transistor (LT1) and a second transistor (LT2) that have a same channel type;
a first electrode of the first transistor (LT1) is connected to a first voltage inputting terminal (28), and a second electrode of the first transistor (LT1) and a grid electrode of the first transistor (LT1) are connected to the first node (A); and
a first electrode of the second transistor (LT2) is connected to the first node (A), and a second electrode of the second transistor (LT2) and a grid electrode of the second transistor (LT2) are connected to a second voltage inputting terminal (29).

5. The pixel circuit according to any one of claims 1 to 4, wherein the first driving circuit (21) comprises:
a first capacitor (C1), wherein a first electrode of the first capacitor (C1) is connected to the first power-supply terminal (25), and a second electrode of the first capacitor (C1) is connected to a grid electrode of the first driving transistor (DT1);
a first resetting module (81) configured for, at a first resetting stage, transmitting a signal of a first initialized-voltage terminal (VINN) to the grid electrode of the first driving transistor (DT1) and the second electrode of the first capacitor (C1);
a first writing module (82) configured for, at a first writing stage, writing a data signal of a first data writing terminal (Data1) into the source electrode of the first driving transistor (DT1);
a first compensating module (83) configured for, at the first writing stage, conducting the drain electrode of the first driving transistor (DT1) with the grid electrode of the first driving transistor (DT1); and
a first light-emission controlling module (84) configured for, at the first resetting stage and the first writing stage, disconnecting the source electrode of the first driving transistor (DT1) from the first power-supply terminal (25), disconnecting the drain electrode of the first driving transistor (DT1) from the first electrode of the first light emitting device (22), and, at a light-emission stage, conducting the source electrode of the first driving transistor (DT1) with the first power-supply terminal (25), and conducting the drain electrode of the first driving transistor (DT1) with the first electrode of the first light emitting device (22); and
the second driving circuit (24) comprises:
a second capacitor (C2), wherein a first electrode of the second capacitor (C2) is connected to the second power-supply terminal (26), and a second electrode of the second capacitor (C2) is connected to a grid electrode of the second driving transistor (DT2);
a second resetting module (85) configured for, at a second resetting stage, transmitting a signal of a second initialized-voltage terminal (VINP) to the grid electrode of the second driving transistor (DT2) and the second electrode of the second capacitor (C2);
a second writing module (86) configured for, at a second writing stage, writing a data signal of a second data writing terminal (Data2) into the source electrode of the second driving transistor (DT2);
a second compensating module (87) configured for, at the second writing stage, conducting the drain electrode of the second driving transistor (DT2) with the grid electrode of the second driving transistor (DT2); and
a second light-emission controlling module (88) configured for, at the second resetting stage and the second writing stage, disconnecting the source electrode of the second driving transistor (DT2) from the second power-supply terminal (26), disconnecting the drain electrode of the second driving transistor (DT2) from the first electrode of the second light emitting device (23), and, at the light-emission stage, conducting the source electrode of the second driving transistor (DT2) with the second power-supply terminal (26), and conducting the drain electrode of the second driving transistor (DT2) with the first electrode of the second light emitting device (23).

6. A light emitting base plate, **characterized in that** the light emitting base plate comprises the pixel circuit according to any one of claims 1 to 5.

7. The light emitting base plate according to claim 6, wherein the light emitting base plate comprises a plurality of pixel units (110), and the first light emitting device (22) and the second light emitting device (23) are located in a same pixel unit (110);
wherein in the same pixel unit (110), the pixel circuit further comprises a third light emitting device (111) and a third driving circuit (112);
the third driving circuit (112) comprises a third driving transistor (DT3), a source electrode of the third driving transistor (DT3) is connected to the second power-supply terminal (26), and a drain electrode of the third driving transistor (DT3) is connected to a first electrode of the third light emitting device (111);
a second electrode of the third light emitting device (111) is connected to the second electrode of the first light emitting device (22) and the second electrode of the second light emitting device (23); and
a channel type of the third driving transistor (DT3) and the channel type of the second driving transistor (DT2) are the same.

8. The light emitting base plate according to claim 7, wherein the first light emitting device (22) is a light emitting device capable of emitting a blue light, the second light emitting device (23) is a light emitting device capable of emitting a green light, and the third light emitting device (111) is a light emitting device capable of emitting a red light.

9. The light emitting base plate according to claim 7, wherein the plurality of pixel units (110) comprise a first pixel unit (1101) and/or a second pixel unit (1102), and the first pixel unit (1101) and the second pixel unit (1102) comprise the pixel circuit;
in the first pixel unit (1101), the channel type of the first driving transistor (DT1) is a P type, the channel type of the second driving transistor (DT2) and the channel type of the third driving transistor (DT3) are an N type, the first electrode of the first light emitting device (22) is an anode, the first electrode of the second light emitting device (23) and the first electrode of the third light emitting device (111) are a cathode, and a voltage inputted by the first power-supply terminal (25) is greater than a voltage inputted by the second power-supply terminal (26); and
in the second pixel unit (1102), the channel type of the first driving transistor (DT1) is an N type, the channel type of the second driving transistor (DT2) and the channel type of the third driving transistor (DT3) are a P type, the first electrode of the first light emitting device (22) is a cathode, the first electrode of the second light emitting device (23) and the first electrode of the third light emitting device (111) are an anode, and a voltage inputted by the first power-supply terminal (25) is less than a voltage inputted by the second power-supply terminal (26).

10. The light emitting base plate according to claim 9, wherein when the plurality of pixel units (110) comprise the first pixel unit (1101) and the second pixel unit (1102), the first pixel unit (1101) and the second pixel unit (1102) satisfy any one of the following conditions:
the first pixel unit (1101) and the second pixel unit (1102) are located at different scanning lines of two neighboring scanning lines;
the first pixel unit (1101) and the second pixel unit (1102) are located at different data columns of two neighboring data columns; and
at least one of neighboring pixel units (110) of the first pixel unit (1101) is the second pixel unit (1102), and at least one of neighboring pixel units (110) of the second pixel unit (1102) is the first pixel unit (1101).

11. The light emitting base plate according to claim 6, wherein the light emitting base plate comprises a plurality of pixel units (110), the plurality of pixel units (110) comprise a third pixel unit (1103) and a fourth pixel unit (1104), the first light emitting device (22) is located in the third pixel unit (1103), and the second light emitting device (23) is located in the fourth pixel unit (1104);
wherein the third pixel unit (1103) comprises one or more first sub-pixel units (141), each of the first sub-pixel units (141) is provided with one instance of the first light emitting device (22) and one instance of the first driving circuit (21), and the first light emitting devices (22) in different instances of the first sub-pixel units (141) are different;
the fourth pixel unit (1104) comprises one or more second sub-pixel units (142), each of the second sub-pixel units (142) is provided with one instance of the second light emitting device (23) and one instance of the second driving circuit (24), and the second light emitting devices (23) in different instances of the second sub-pixel units (142) are different; and
the second electrode of any one of the first light emitting devices (22) of the third pixel units (110) is connected to the second electrodes of the second light emitting devices (23) of the fourth pixel units (110).

12. The light emitting base plate according to claim 11, wherein the third pixel unit (1103) and the fourth pixel unit (1104) are two neighboring pixel units (110), and the third pixel unit (1103) and the fourth pixel unit (1104) satisfy any one of the following conditions:
the third pixel unit (1103) and the fourth pixel unit (1104) are located at different scanning lines of two neighboring scanning lines;
the third pixel unit (1103) and the fourth pixel unit (1104) are located at different data columns of two neighboring data columns; and
a neighboring pixel unit of the third pixel unit (1103) is the fourth pixel unit (1104), and a neighboring pixel unit of the fourth pixel unit (1104) is the third pixel unit (1103).

13. A light emitting apparatus, **characterized in that** the light emitting apparatus comprises the light emitting base plate according to any one of claims 6 to 12.

14. A driving method of a pixel circuit, **characterized in that** the method is for driving the pixel circuit according to any one of claims 1 to 5, and the driving method comprises:
at the light-emission stage, controlling the first light emitting device (22) and the second light emitting device (23) to synchronously emit light.

15. The driving method according to claim 14, wherein when the first driving circuit (21) comprises the first capacitor (C1), the first resetting module (81), the first writing module (82), the first compensating module and the first light-emission controlling module (84), and the second driving circuit (24) comprises the second capacitor (C2), the second resetting module (85), the second writing module (86), the second compensating module (87) and the second light-emission controlling module (88), before the light-emission stage, the method further comprises:
at the first resetting stage, controlling the signal of the first initialized-voltage terminal (VINN) to be transmitted to the grid electrode of the first driving transistor (DT1) and the second electrode of the first capacitor (C1), controlling the source electrode of the first driving transistor (DT1) to be disconnected from the first power-supply terminal (25), and controlling the drain electrode of the first driving transistor (DT1) to be disconnected from the first electrode of the first light emitting device (22);
at the first writing stage, controlling the data signal of the first data writing terminal (Data1) to be written into the source electrode of the first driving transistor (DT1), controlling the drain electrode of the first driving transistor (DT1) to be conducted with the grid electrode of the first driving transistor (DT1), controlling the source electrode of the first driving transistor (DT1) to be disconnected from the first power-supply terminal (25), and controlling the drain electrode of the first driving transistor (DT1) to be disconnected from the first electrode of the first light emitting device (22);
at the second resetting stage, controlling the signal of the second initialized-voltage terminal (VINP) to be transmitted to the grid electrode of the second driving transistor (DT2) and the second electrode of the second capacitor (C2), controlling the source electrode of the second driving transistor (DT2) to be disconnected from the second power-supply terminal (26), and controlling the drain electrode of the second driving transistor (DT2) to be disconnected from the first electrode of the second light emitting device (23); and
at the second writing stage, controlling the data signal of the second data writing terminal (Data2) to be written into the source electrode of the second driving transistor (DT2), controlling the drain electrode of the second driving transistor (DT2) to be conducted with the grid electrode of the second driving transistor (DT2), controlling the source electrode of the second driving transistor (DT2) to be disconnected from the second power-supply terminal (26), and controlling the drain electrode of the second driving transistor (DT2) to be disconnected from the first electrode of the second light emitting device (23);
at the light-emission stage, the method further comprises: controlling the source electrode of the first driving transistor (DT1) to be conducted with the first power-supply terminal (25), controlling the drain electrode of the first driving transistor (DT1) to be conducted with the first electrode of the first light emitting device (22), controlling the source electrode of the second driving transistor (DT2) to be conducted with the second power-supply terminal (26), and controlling the drain electrode of the second driving transistor (DT2) to be conducted with the first electrode of the second light emitting device (23); and
the second resetting stage and the first writing stage proceed synchronously.

## Patentansprüche

1. Pixelschaltung, wobei die Pixelschaltung eine erste Ansteuerschaltung (21), eine erste Leuchtvorrichtung (22), eine zweite Leuchtvorrichtung (23) und eine zweite Ansteuerschaltung (24) umfasst, die nacheinander in Reihe geschaltet sind;
die erste Ansteuerschaltung (21) einen ersten Ansteuertransistor (DT1) umfasst, eine Source-Elektrode des ersten Ansteuertransistors (DT1) mit einem ersten Stromversorgungsanschluss (25) verbunden ist, und eine Drain-Elektrode des ersten Ansteuertransistors (DT1) mit einer ersten Elektrode der ersten Leuchtvorrichtung (22) verbunden ist;
die zweite Ansteuerschaltung (24) einen zweiten Ansteuertransistor (DT2) umfasst,
**dadurch gekennzeichnet, dass** eine Source-Elektrode des zweiten Ansteuertransistors (DT2) mit einem zweiten Stromversorgungsanschluss (26) verbunden ist und eine Drain-Elektrode des zweiten Ansteuertransistors (DT2) mit einer ersten Elektrode der zweiten Leuchtvorrichtung (23) verbunden ist;
eine zweite Elektrode der ersten Leuchtvorrichtung (22) mit einer zweiten Elektrode der zweiten Leuchtvorrichtung (23) verbunden ist; und
ein Kanaltyp des ersten Ansteuertransistors (DT1) und ein Kanaltyp des zweiten Ansteuertransistors (DT2) verschieden sind;
wobei eine der ersten Leuchtvorrichtung (22) und der zweiten Leuchtvorrichtung (23) eine Leuchtvorrichtung ist, die in der Lage ist, ein blaues Licht auszusenden, und die andere eine Leuchtvorrichtung ist, die in der Lage ist, ein grünes Licht oder ein rotes Licht auszusenden.

2. Pixelschaltung nach Anspruch 1, wobei der Kanaltyp des ersten Ansteuertransistors (DT1) ein P-Typ ist, der Kanaltyp des zweiten Ansteuertransistors (DT2) ein N-Typ ist, die erste Elektrode der ersten Leuchtvorrichtung (22) eine Anode ist, die erste Elektrode der zweiten Leuchtvorrichtung (23) eine Kathode ist, und eine durch den ersten Stromversorgungsanschluss (25) eingegebene Spannung größer ist als eine durch den zweiten Stromversorgungsanschluss (26) eingegebene Spannung; oder
der Kanaltyp des ersten Ansteuertransistors (DT1) ein N-Typ ist, der Kanaltyp des zweiten Ansteuertransistors (DT2) ein P-Typ ist, die erste Elektrode der ersten Leuchtvorrichtung (22) eine Kathode ist, die erste Elektrode der zweiten Leuchtvorrichtung (23) eine Anode ist, und eine durch den ersten Stromversorgungsanschluss (25) eingegebene Spannung kleiner ist als eine durch den zweiten Stromversorgungsanschluss (26) eingegebene Spannung.

3. Pixelschaltung nach Anspruch 1, wobei die Pixelschaltung des Weiteren umfasst:
eine Ableitkomponente (27), die mit einem ersten Knoten (A) verbunden ist, wobei der erste Knoten (A) mit der zweiten Elektrode der ersten Leuchtvorrichtung (22) und der zweiten Elektrode der zweiten Leuchtvorrichtung (23) verbunden ist, so dass eine Differenz zwischen einem elektrischen Strom in der ersten Leuchtvorrichtung (22) und einem elektrischen Strom in der zweiten Leuchtvorrichtung (23) gleich einem elektrischen Strom in der Ableitkomponente (27) ist.

4. Pixelschaltung nach Anspruch 3, wobei die Ableitkomponente (27) einen ersten Transistor (LT1) und einen zweiten Transistor (LT2) umfasst, die denselben Kanaltyp haben;
eine erste Elektrode des ersten Transistors (LT1) mit einem ersten Spannungseingangsanschluss (28) verbunden ist, und eine zweite Elektrode des ersten Transistors (LT1) und eine Gitterelektrode des ersten Transistors (LT1) mit dem ersten Knoten (A) verbunden sind; und
eine erste Elektrode des zweiten Transistors (LT2) mit dem ersten Knoten (A) verbunden ist, und eine zweite Elektrode des zweiten Transistors (LT2) und eine Gitterelektrode des zweiten Transistors (LT2) mit einem zweiten Spannungseingangsanschluss (29) verbunden sind.

5. Pixelschaltung nach einem der Ansprüche 1 bis 4, wobei die erste Ansteuerschaltung (21) umfasst:
einen ersten Kondensator (C1), wobei eine erste Elektrode des ersten Kondensators (C1) mit dem ersten Stromversorgungsanschluss (25) verbunden ist, und eine zweite Elektrode des ersten Kondensators (C1) mit einer Gitterelektrode des ersten Ansteuertransistors (DT1) verbunden ist;
ein erstes Rücksetzmodul (81), das eingerichtet ist zum, auf einer ersten Rücksetzstufe, Senden eines Signals eines ersten Initialisiertspannungsanschlusses (VINN) an die Gitterelektrode des ersten Ansteuertransistors (DT1) und die zweite Elektrode des ersten Kondensators (C1);
ein erstes Schreibmodul (82), das eingerichtet ist zum, auf einer ersten Schreibstufe, Schreiben eines Datensignals eines ersten Datenschreibanschlusses (Data1) in die Source-Elektrode des ersten Ansteuertransistors (DT1);
ein erstes Kompensationsmodul (83), das eingerichtet ist zum, auf der ersten Schreibstufe, Leiten der Drain-Elektrode des ersten Ansteuertransistors (DT1) mit der Gitterelektrode des ersten Ansteuertransistors (DT1); und
ein erstes Leuchtsteuermodul (84), das eingerichtet ist zum, auf der ersten Rücksetzstufe und der ersten Schreibstufe, Trennen der Source-Elektrode des ersten Ansteuertransistors (DT1) von dem ersten Stromversorgungsanschluss (25), Trennen der Drain-Elektrode des ersten Ansteuertransistors (DT1) von der ersten Elektrode der ersten Leuchtvorrichtung (22), und, auf einer Leuchtstufe, Leiten der Source-Elektrode des ersten Ansteuertransistors (DT1) mit dem ersten Stromversorgungsanschluss (25) und Leiten der Drain-Elektrode des ersten Ansteuertransistors (DT1) mit der ersten Elektrode der ersten Leuchtvorrichtung (22); und
die zweite Ansteuerschaltung (24) umfasst:
einen zweiten Kondensator (C2), wobei eine erste Elektrode des zweiten Kondensators (C2) mit dem zweiten Stromversorgungsanschluss (26) verbunden ist, und eine zweite Elektrode des zweiten Kondensators (C2) mit einer Gitterelektrode des zweiten Ansteuertransistors (DT2) verbunden ist;
ein zweites Rücksetzmodul (85), das eingerichtet ist zum, auf einer zweiten Rücksetzstufe, Senden eines Signals eines zweiten Initialisiertspannungsanschlusses (VINP) an die Gitterelektrode des zweiten Ansteuertransistors (DT2) und die zweite Elektrode des zweiten Kondensators (C2);
ein zweites Schreibmodul (86), das eingerichtet ist zum, auf einer zweiten Schreibstufe, Schreiben eines Datensignals eines zweiten Datenschreibanschlusses (Data2) in die Source-Elektrode des zweiten Ansteuertransistors (DT2);
ein zweites Kompensationsmodul (87), das eingerichtet ist zum, auf der zweiten Schreibstufe, Leiten der Drain-Elektrode des zweiten Ansteuertransistors (DT2) mit der Gitterelektrode des zweiten Ansteuertransistors (DT2); und
ein zweites Leuchtsteuermodul (88), das eingerichtet ist zum, auf der zweiten Rücksetzstufe und der zweiten Schreibstufe, Trennen der Source-Elektrode des zweiten Ansteuertransistors (DT2) von dem zweiten Stromversorgungsanschluss (26), Trennen der Drain-Elektrode des zweiten Ansteuertransistors (DT2) von der ersten Elektrode der zweiten Leuchtvorrichtung (23), und, auf der Leuchtstufe, Leiten der Source-Elektrode des zweiten Ansteuertransistors (DT2) mit dem zweiten Stromversorgungsanschluss (26) und Leiten der Drain-Elektrode des zweiten Ansteuertransistors (DT2) mit der ersten Elektrode der zweiten Leuchtvorrichtung (23).

6. Leucht-Grundplatte, **dadurch gekennzeichnet, dass** die Leucht-Grundplatte die Pixelschaltung nach einem der Ansprüche 1 bis 5 umfasst.

7. Leucht-Grundplatte nach Anspruch 6, wobei die Leucht-Grundplatte mehrere Pixeleinheiten (110) umfasst, und die erste Leuchtvorrichtung (22) und die zweite Leuchtvorrichtung (23) sich in einer selben Pixeleinheit (110) befinden;
wobei die Pixelschaltung in derselben Pixeleinheit (110) des Weiteren eine dritte Leuchtvorrichtung (111) und eine dritte Ansteuerschaltung (112) umfasst;
die dritte Ansteuerschaltung (112) einen dritten Ansteuertransistor (DT3) umfasst, eine Source-Elektrode des dritten Ansteuertransistors (DT3) mit dem zweiten Stromversorgungsanschluss (26) verbunden ist, und eine Drain-Elektrode des dritten Ansteuertransistors (DT3) mit einer ersten Elektrode der dritten Leuchtvorrichtung (111) verbunden ist;
eine zweite Elektrode der dritten Leuchtvorrichtung (111) mit der zweiten Elektrode der ersten Leuchtvorrichtung (22) und der zweiten Elektrode der zweiten Leuchtvorrichtung (23) verbunden ist; und
ein Kanaltyp des dritten Ansteuertransistors (DT3) und der Kanaltyp des zweiten Ansteuertransistors (DT2) gleich sind.

8. Leucht-Grundplatte nach Anspruch 7, wobei die erste Leuchtvorrichtung (22) eine Leuchtvorrichtung ist, die in der Lage ist, ein blaues Licht auszusenden, die zweite Leuchtvorrichtung (23) eine Leuchtvorrichtung ist, die in der Lage ist, ein grünes Licht auszusenden, und die dritte Leuchtvorrichtung (111) eine Leuchtvorrichtung ist, die in der Lage ist, ein rotes Licht auszusenden.

9. Leucht-Grundplatte nach Anspruch 7, wobei die mehreren Pixeleinheiten (110) eine erste Pixeleinheit (1101) und/oder eine zweite Pixeleinheit (1102) umfassen, und die erste Pixeleinheit (1101) und die zweite Pixeleinheit (1102) die Pixelschaltung umfassen;
in der ersten Pixeleinheit (1101) der Kanaltyp des ersten Ansteuertransistors (DT1) ein P-Typ ist, der Kanaltyp des zweiten Ansteuertransistors (DT2) und der Kanaltyp des dritten Ansteuertransistors (DT3) ein N-Typ sind, die erste Elektrode der ersten Leuchtvorrichtung (22) eine Anode ist, die erste Elektrode der zweiten Leuchtvorrichtung (23) und die erste Elektrode der dritten Leuchtvorrichtung (111) eine Kathode sind, und eine durch den ersten Stromversorgungsanschluss (25) eingegebene Spannung größer ist als eine durch den zweiten Stromversorgungsanschluss (26) eingegebene Spannung; und
in der zweiten Pixeleinheit (1102) der Kanaltyp des ersten Ansteuertransistors (DT1) ein N-Typ ist, der Kanaltyp des zweiten Ansteuertransistors (DT2) und der Kanaltyp des dritten Ansteuertransistors (DT3) ein P-Typ sind, die erste Elektrode der ersten Leuchtvorrichtung (22) eine Kathode ist, die erste Elektrode der zweiten Leuchtvorrichtung (23) und die erste Elektrode der dritten Leuchtvorrichtung (111) eine Anode sind, und eine durch den ersten Stromversorgungsanschluss (25) eingegebene Spannung kleiner ist als eine durch den zweiten Stromversorgungsanschluss (26) eingegebene Spannung.

10. Leucht-Grundplatte nach Anspruch 9, wobei, wenn die mehreren Pixeleinheiten (110) die erste Pixeleinheit (1101) und die zweite Pixeleinheit (1102) umfassen, die erste Pixeleinheit (1101) und die zweite Pixeleinheit (1102) eine der folgenden Bedingungen erfüllen:
die erste Pixeleinheit (1101) und die zweite Pixeleinheit (1102) befinden sich auf verschiedenen Abtastzeilen von zwei benachbarten Abtastzeilen;
die erste Pixeleinheit (1101) und die zweite Pixeleinheit (1102) befinden sich in verschiedenen Datenspalten von zwei benachbarten Datenspalten; und
mindestens eine von benachbarten Pixeleinheiten (110) der ersten Pixeleinheit (1101) ist die zweite Pixeleinheit (1102), und mindestens eine von benachbarten Pixeleinheiten (110) der zweiten Pixeleinheit (1102) ist die erste Pixeleinheit (1101).

11. Leucht-Grundplatte nach Anspruch 6, wobei die Leucht-Grundplatte mehrere Pixeleinheiten (110) umfasst, die mehreren Pixeleinheiten (110) eine dritte Pixeleinheit (1103) und eine vierte Pixeleinheit (1104) umfassen, die erste Leuchtvorrichtung (22) sich in der dritten Pixeleinheit (1103) befindet, und die zweite Leuchtvorrichtung (23) sich in der vierten Pixeleinheit (1104) befindet;
wobei die dritte Pixeleinheit (1103) eine oder mehrere erste Subpixeleinheiten (141) umfasst, jede der ersten Subpixeleinheiten (141) mit einer Instanz der ersten Leuchtvorrichtung (22) und einer Instanz der ersten Ansteuerschaltung (21) versehen ist, und die ersten Leuchtvorrichtungen (22) in verschiedenen Instanzen der ersten Subpixeleinheiten (141) verschieden sind;
die vierte Pixeleinheit (1104) eine oder mehrere zweite Subpixeleinheiten (142) umfasst, wobei jede der zweiten Subpixeleinheiten (142) mit einer Instanz der zweiten Leuchtvorrichtung (23) und einer Instanz der zweiten Ansteuerschaltung (24) versehen ist, und die zweiten Leuchtvorrichtungen (23) in verschiedenen Instanzen der zweiten Subpixeleinheiten (142) verschieden sind; und
die zweite Elektrode einer der ersten Leuchtvorrichtungen (22) der dritten Pixeleinheiten (110) mit den zweiten Elektroden der zweiten Leuchtvorrichtungen (23) der vierten Pixeleinheiten (110) verbunden ist.

12. Leucht-Grundplatte nach Anspruch 11, wobei die dritte Pixeleinheit (1103) und die vierte Pixeleinheit (1104) zwei benachbarte Pixeleinheiten (110) sind, und die dritte Pixeleinheit (1103) und die vierte Pixeleinheit (1104) eine der folgenden Bedingungen erfüllen:
die dritte Pixeleinheit (1103) und die vierte Pixeleinheit (1104) befinden sich auf verschiedenen Abtastzeilen von zwei benachbarten Abtastzeilen;
die dritte Pixeleinheit (1103) und die vierte Pixeleinheit (1104) befinden sich in verschiedenen Datenspalten von zwei benachbarten Datenspalten; und
eine benachbarte Pixeleinheit der dritten Pixeleinheit (1103) ist die vierte Pixeleinheit (1104), und eine benachbarte Pixeleinheit der vierten Pixeleinheit (1104) ist die dritte Pixeleinheit (1103).

13. Leuchtgerät, **dadurch gekennzeichnet, dass** das Leuchtgerät die Leucht-Grundplatte nach einem der Ansprüche 6 bis 12 umfasst.

14. Ansteuerverfahren einer Pixelschaltung, **dadurch gekennzeichnet, dass** das Verfahren zum Ansteuern der Pixelschaltung nach einem der Ansprüche 1 bis 5 dient und dass das Ansteuerverfahren umfasst:
auf der Leuchtstufe, Steuern der ersten Leuchtvorrichtung (22) und der zweiten Leuchtvorrichtung (23) so, dass sie synchron leuchten.

15. Ansteuerverfahren nach Anspruch 14, wobei, wenn die erste Ansteuerschaltung (21) den ersten Kondensator (C1), das erste Rücksetzmodul (81), das erste Schreibmodul (82), das erste Kompensationsmodul und das erste Leuchtsteuermodul (84) umfasst und die zweite Ansteuerschaltung (24) den zweiten Kondensator (C2), das zweite Rücksetzmodul (85), das zweite Schreibmodul (86), das zweite Kompensationsmodul (87) und das zweite Leuchtsteuermodul (88) umfasst, das Verfahren vor der Leuchtstufe des Weiteren umfasst:
auf der ersten Rücksetzstufe, Steuern des Signals des ersten Initialisiertspannungsanschlusses (VINN) so, dass es an die Gitterelektrode des ersten Ansteuertransistors (DT1) und die zweite Elektrode des ersten Kondensators (C1) gesendet wird, Steuern der Source-Elektrode des ersten Ansteuertransistors (DT1) so, dass sie von dem ersten Stromversorgungsanschluss (25) getrennt wird, und Steuern der Drain-Elektrode des ersten Ansteuertransistors (DT1) so, dass sie von der ersten Elektrode der ersten Leuchtvorrichtung (22) getrennt wird;
auf der ersten Schreibstufe, Steuern des Datensignals des ersten Datenschreibanschlusses (Data1) so, dass es in die Source-Elektrode des ersten Ansteuertransistors (DT1) geschrieben wird, Steuern der Drain-Elektrode des ersten Ansteuertransistors (DT1) so, dass sie mit der Gitterelektrode des ersten Ansteuertransistors (DT1) geleitet wird, Steuern der Source-Elektrode des ersten Ansteuertransistors (DT1) so, dass sie von dem ersten Stromversorgungsanschluss (25) getrennt wird, und Steuern der Drain-Elektrode des ersten Ansteuertransistors (DT1) so, dass sie von der ersten Elektrode der ersten Leuchtvorrichtung (22) getrennt wird;
auf der zweiten Rücksetzstufe, Steuern des Signals des zweiten Initialisiertspannungsanschlusses (VINP) so, dass es an die Gitterelektrode des zweiten Ansteuertransistors (DT2) und die zweite Elektrode des zweiten Kondensators (C2) gesendet wird, Steuern der Source-Elektrode des zweiten Ansteuertransistors (DT2) so, dass sie von dem zweiten Stromversorgungsanschluss (26) getrennt wird, und Steuern der Drain-Elektrode des zweiten Ansteuertransistors (DT2) so, dass sie von der ersten Elektrode der zweiten Leuchtvorrichtung (23) getrennt wird; und
auf der zweiten Schreibstufe, Steuern des Datensignals des zweiten Datenschreibanschlusses (Data2) so, dass es in die Source-Elektrode des zweiten Ansteuertransistors (DT2) geschrieben wird, Steuern der Drain-Elektrode des zweiten Ansteuertransistors (DT2) so, dass sie mit der Gitterelektrode des zweiten Ansteuertransistors (DT2) geleitet wird, Steuern der Source-Elektrode des zweiten Ansteuertransistors (DT2) so, dass sie von dem zweiten Stromversorgungsanschluss (26) getrennt wird, und Steuern der Drain-Elektrode des zweiten Ansteuertransistors (DT2) so, dass sie von der ersten Elektrode der zweiten Leuchtvorrichtung (23) getrennt wird;
wobei das Verfahren auf der Leuchtstufe des Weiteren umfasst: Steuern der Source-Elektrode des ersten Ansteuertransistors (DT1) so, dass sie mit dem ersten Stromversorgungsanschluss (25) geleitet wird, Steuern der Drain-Elektrode des ersten Ansteuertransistors (DT1) so, dass sie mit der ersten Elektrode der ersten Leuchtvorrichtung (22) geleitet wird, Steuern der Source-Elektrode des zweiten Ansteuertransistors (DT2) so, dass sie mit dem zweiten Stromversorgungsanschluss (26) geleitet wird, und Steuern der Drain-Elektrode des zweiten Ansteuertransistors (DT2) so, dass sie mit der ersten Elektrode der zweiten Leuchtvorrichtung (23) geleitet wird; und
wobei die zweite Rücksetzstufe und die erste Schreibstufe synchron stattfinden.

## Revendications

1. Circuit de pixels, dans lequel ledit circuit de pixels comprend un premier circuit d'attaque (21), un premier dispositif électroluminescent (22), un deuxième dispositif électroluminescent (23), et un deuxième circuit d'attaque (24), qui sont connectés en série de manière séquentielle ;
le premier circuit d'attaque (21) comprend un premier transistor d'attaque (DT1), une électrode de source du premier transistor d'attaque (DT1) étant connectée à une première borne d'alimentation (25), et une électrode de drain du premier transistor d'attaque (DT1) étant connectée à une première électrode du premier dispositif électroluminescent (22) ;
le deuxième circuit d'attaque (24) comprend un deuxième transistor d'attaque (DT2),
**caractérisé en ce qu'**une électrode de source du deuxième transistor d'attaque (DT2) est connectée à une seconde borne d'alimentation (26), et qu'une électrode de drain du deuxième transistor d'attaque (DT2) est connectée à une première électrode du deuxième dispositif électroluminescent (23) ;
une seconde électrode du premier dispositif électroluminescent (22) est connectée à une seconde électrode du deuxième dispositif électroluminescent (23) ; et
un type de canal du premier transistor d'attaque (DT1) et un type de canal du deuxième transistor d'attaque (DT2) sont différents ;
dans lequel l'un du premier dispositif électroluminescent (22) et du deuxième dispositif électroluminescent (23) est un dispositif électroluminescent susceptible d'émettre une lumière bleue, et l'autre est un dispositif électroluminescent susceptible d'émettre une lumière verte ou une lumière rouge.

2. Circuit de pixels selon la revendication 1, dans lequel le type de canal du premier transistor d'attaque (DT1) est de type P, le type de canal du deuxième transistor d'attaque (DT2) est de type N, la première électrode du premier dispositif électroluminescent (22) est une anode, la première électrode du deuxième dispositif électroluminescent (23) est une cathode, et une tension fournie par la première borne d'alimentation (25) est supérieure à une tension fournie par la seconde borne d'alimentation (26) ; ou
le type de canal du premier transistor d'attaque (DT1) est de type N, le type de canal du deuxième transistor d'attaque (DT2) est de type P, la première électrode du premier dispositif électroluminescent (22) est une cathode, la première électrode du deuxième dispositif électroluminescent (23) est une anode, et la tension fournie par la première borne d'alimentation (25) est inférieure à la tension fournie par la seconde borne d'alimentation (26).

3. Circuit de pixels selon la revendication 1, dans lequel le circuit de pixels comprend en outre :
un composant de fuite (27), connecté à un premier nœud (A), dans lequel le premier nœud (A) est connecté à la seconde électrode du premier dispositif électroluminescent (22) et à la seconde électrode du deuxième dispositif électroluminescent (23), de sorte qu'une différence entre un courant électrique dans le premier dispositif électroluminescent (22) et un courant électrique dans le deuxième dispositif électroluminescent (23) soit égale à un courant électrique dans le composant de fuite (27).

4. Circuit de pixels selon la revendication 3, dans lequel le composant de fuite (27) comprend un premier transistor (LT1) et un second transistor (LT2) qui ont un même type de canal ;
une première électrode du premier transistor (LT1) est connectée à une première borne d'entrée de tension (28), et une seconde électrode du premier transistor (LT1) et une électrode de grille du premier transistor (LT1) sont connectées au premier nœud (A) ; et
une première électrode du second transistor (LT2) est connectée au premier nœud (A), et une seconde électrode du second transistor (LT2) et une électrode de grille du second transistor (LT2) sont connectées à une seconde borne d'entrée de tension (29).

5. Circuit de pixels selon l'une quelconque des revendications 1 à 4, dans lequel le premier circuit d'attaque (21) comprend :
un premier condensateur (C1), dans lequel une première électrode du premier condensateur (C1) est connectée à la première borne d'alimentation (25), et une seconde électrode du premier condensateur (C1) est connectée à une électrode de grille du premier transistor d'attaque (DT1) ;
un premier module de réinitialisation (81) configuré pour, à une première étape de réinitialisation, transmettre un signal d'une première borne de tension initialisée (VINN) à l'électrode de grille du premier transistor d'attaque (DT1) et à la seconde électrode du premier condensateur (C1) ;
un premier module d'écriture (82) configuré pour, à une première étape d'écriture, écrire un signal de données d'une première borne d'écriture de données (Data1) dans l'électrode de source du premier transistor d'attaque (DT1) ;
un premier module de compensation (83) configuré pour, à la première étape d'écriture, mettre en conduction l'électrode de drain du premier transistor d'attaque (DT1) avec l'électrode de grille du premier transistor d'attaque (DT1) ; et
un premier module de commande d'émission de lumière (84) configuré pour, à la première étape de réinitialisation et à la première étape d'écriture, déconnecter l'électrode de source du premier transistor d'attaque (DT1) de la première borne d'alimentation (25), déconnecter l'électrode de drain du premier transistor d'attaque (DT1) de la première électrode du premier dispositif électroluminescent (22), et, à une étape d'émission de lumière, mettre en conduction l'électrode de source du premier transistor d'attaque (DT1) avec la première borne d'alimentation (25), et mettre en conduction l'électrode de drain du premier transistor d'attaque (DT1) avec la première électrode du premier dispositif électroluminescent (22) ; et
le deuxième circuit d'attaque (24) comprend :
un second condensateur (C2), dans lequel une première électrode du second condensateur (C2) est connectée à la seconde borne d'alimentation (26), et une seconde électrode du second condensateur (C2) est connectée à une électrode de grille du deuxième transistor d'attaque (DT2) ;
un second module de réinitialisation (85) configuré pour, à une seconde étape de réinitialisation, transmettre un signal d'une seconde borne de tension initialisée (VINP) à l'électrode de grille du deuxième transistor d'attaque (DT2) et à la seconde électrode du second condensateur (C2) ;
un second module d'écriture (86) configuré pour, à une seconde étape d'écriture, écrire un signal de données d'une seconde borne d'écriture de données (Data2) dans l'électrode de source du deuxième transistor d'attaque (DT2) ;
un second module de compensation (87) configuré pour, à la seconde étape d'écriture, mettre en conduction l'électrode de drain du deuxième transistor d'attaque (DT2) avec l'électrode de grille du deuxième transistor d'attaque (DT2) ; et
un second module de commande d'émission de lumière (88) configuré pour, à la première étape de réinitialisation et à la seconde étape d'écriture, déconnecter l'électrode de source du deuxième transistor d'attaque (DT2) de la seconde borne d'alimentation (26), déconnecter l'électrode de drain du deuxième transistor d'attaque (DT2) de la première électrode du deuxième dispositif électroluminescent (23), et, à l'étape d'émission de lumière, mettre en conduction l'électrode de source du deuxième transistor d'attaque (DT2) avec la seconde borne d'alimentation (26), et mettre en conduction l'électrode de drain du deuxième transistor d'attaque (DT2) avec la première électrode du deuxième dispositif électroluminescent (23).

6. Plaque de base électroluminescente, **caractérisée en ce que** la plaque de base électroluminescente comprend le circuit de pixels selon l'une quelconque des revendications 1 à 5.

7. Plaque de base électroluminescente selon la revendication 6, dans laquelle la plaque de base électroluminescente comprend une pluralité d'unités de pixels (110), et le premier dispositif électroluminescent (22) et le deuxième dispositif électroluminescent (23) sont situés dans une même unité de pixel (110) ;
dans laquelle, dans la même unité de pixel (110), le circuit de pixels comprend en outre un troisième dispositif électroluminescent (111) et un troisième circuit d'attaque (112) ;
le troisième circuit d'attaque (112) comprend un troisième transistor d'attaque (DT3), une électrode de source du troisième transistor d'attaque (DT3) est connectée à la seconde borne d'alimentation (26), et une électrode de drain du troisième transistor d'attaque (DT3) est connectée à une première électrode du troisième dispositif électroluminescent (111) ;
une seconde électrode du troisième dispositif électroluminescent (111) est connectée à la seconde électrode du premier dispositif électroluminescent (22) et à la seconde électrode du deuxième dispositif électroluminescent (23) ; et
un type de canal du troisième transistor d'attaque (DT3) et le type de canal du deuxième transistor d'attaque (DT2) sont identiques.

8. Plaque de base électroluminescente selon la revendication 7, dans laquelle le premier dispositif électroluminescent (22) est un dispositif électroluminescent susceptible d'émettre une lumière bleue, le deuxième dispositif électroluminescent (23) est un dispositif électroluminescent susceptible d'émettre une lumière verte, et le troisième dispositif électroluminescent (111) est un dispositif électroluminescent susceptible d'émettre une lumière rouge.

9. Plaque de base électroluminescente selon la revendication 7, dans laquelle la pluralité d'unités de pixels (110) comprend une première unité de pixel (1101) et/ou une deuxième unité de pixel (1102), et la première unité de pixel (1101) et la deuxième unité de pixel (1102) comprennent le circuit de pixels ;
dans la première unité de pixel (1101), le type de canal du premier transistor d'attaque (DT1) est un type P, le type de canal du deuxième transistor d'attaque (DT2) et le type de canal du troisième transistor d'attaque (DT3) sont un type N, la première électrode du premier dispositif électroluminescent (22) est une anode, la première électrode du deuxième dispositif électroluminescent (23) et la première électrode du troisième dispositif électroluminescent (111) sont une cathode, et une tension appliquée par la première borne d'alimentation (25) est supérieure à une tension appliquée par la seconde borne d'alimentation (26) ; et
dans la deuxième unité de pixel (1102), le type de canal du premier transistor d'attaque (DT1) est un type N, le type de canal du deuxième transistor d'attaque (DT2) et le type de canal du troisième transistor de commande (DT3) sont un type P, la première électrode du premier dispositif électroluminescent (22) est une cathode, la première électrode du deuxième dispositif électroluminescent (23) et la première électrode du troisième dispositif électroluminescent (111) sont une anode, et une tension appliquée par la première borne d'alimentation (25) est inférieure à une tension appliquée par la seconde borne d'alimentation (26).

10. Plaque de base électroluminescente selon la revendication 9, dans laquelle lorsque la pluralité d'unités de pixels (110) comprend la première unité de pixel (1101) et la deuxième unité de pixel (1102), la première unité de pixel (1101) et la deuxième unité de pixel (1102) satisfont à l'une quelconque des conditions suivantes :
la première unité de pixel (1101) et la deuxième unité de pixel (1102) sont situées sur des lignes de balayage différentes parmi deux lignes de balayage voisines ;
la première unité de pixel (1101) et la deuxième unité de pixel (1102) sont situées dans des colonnes de données différentes parmi deux colonnes de données voisines ; et
au moins l'une parmi des unités de pixels voisines (110) de la première unité de pixel (1101) est la deuxième unité de pixel (1102), et au moins l'une parmi des unités de pixels voisines (110) de la deuxième unité de pixels (1102) est la première unité de pixel (1101).

11. Plaque de base électroluminescente selon la revendication 6, dans laquelle la plaque de base électroluminescente comprend une pluralité d'unités de pixels (110), la pluralité d'unités de pixels (110) comprend une troisième unité de pixel (1103) et une quatrième unité de pixel (1104), le premier dispositif électroluminescent (22) est situé dans la troisième unité de pixel (1103), et le deuxième dispositif électroluminescent (23) est situé dans la quatrième unité de pixel (1104) ;
dans lequel la troisième unité de pixel (1103) comprend une ou plusieurs premières sous-unités de pixel (141), chacune des premières sous-unités de pixel (141) est munie d'une instance du premier dispositif électroluminescent (22) et d'une instance du premier circuit d'attaque (21), et les premiers dispositifs électroluminescents (22) dans différentes instances des premières sous-unités de pixel (141) sont différents ;
la quatrième unité de pixel (1104) comprend une ou plusieurs secondes sous-unités de pixel (142), chacune des secondes sous-unités de pixel (142) est munie d'une instance du deuxième dispositif électroluminescent (23) et d'une instance du deuxième circuit d'attaque (24), et les deuxièmes dispositifs électroluminescents (23) dans différentes instances des secondes sous-unités de pixel (142) sont différents ; et
la seconde électrode de l'un quelconque des premiers dispositifs électroluminescents (22) des troisièmes unités de pixels (110) est connectée aux secondes électrodes des deuxièmes dispositifs électroluminescents (23) des quatrièmes unités de pixels (110).

12. Plaque de base électroluminescente selon la revendication 11, dans laquelle la troisième unité de pixel (1103) et la quatrième unité de pixel (1104) sont deux unités de pixels voisines (110), et la troisième unité de pixel (1103) et la quatrième unité de pixel (1104) satisfont à l'une quelconque des conditions suivantes :
la troisième unité de pixel (1103) et la quatrième unité de pixel (1104) sont situées sur des lignes de balayage différentes parmi deux lignes de balayage voisines ;
la troisième unité de pixel (1103) et la quatrième unité de pixel (1104) sont situées dans des colonnes de données différentes parmi deux colonnes de données voisines ; et
une unité de pixel voisine de la troisième unité de pixel (1103) est la quatrième unité de pixel (1104), et une unité de pixel voisine de la quatrième unité de pixel (1104) est la troisième unité de pixel (1103).

13. Appareil électroluminescent, **caractérisé en ce que** l'appareil électroluminescent comprend la plaque de base électroluminescente selon l'une quelconque des revendications 6 à 12.

14. Procédé d'attaque d'un circuit de pixels, **caractérisé en ce que** ledit procédé est destiné à attaquer le circuit de pixels selon l'une quelconque des revendications 1 à 5, et **en ce que** le procédé d'attaque comprend :
à l'étape d'émission de lumière, la commande du premier dispositif électroluminescent (22) et du deuxième dispositif électroluminescent (23) pour émettre de la lumière de manière synchrone.

15. Procédé d'attaque selon la revendication 14, dans lequel lorsque le premier circuit d'attaque (21) comprend le premier condensateur (C1), le premier module de réinitialisation (81), le premier module d'écriture (82), le premier module de compensation et le premier module de commande d'émission de lumière (84), et le deuxième circuit d'attaque (24) comprend le second condensateur (C2), le second module de réinitialisation (85), le second module d'écriture (86), le second module de compensation (87) et le second module de commande d'émission de lumière (88), avant l'étape d'émission de lumière, le procédé comprend en outre :
à la première étape de réinitialisation, la commande du signal de la première borne de tension initialisée (VINN) de manière à ce qu'il soit transmis à l'électrode de grille du premier transistor d'attaque (DT1) et à la seconde électrode du premier condensateur (C1), la commande de l'électrode de source du premier transistor de commande (DT1) de manière à ce qu'elle soit déconnectée de la première borne d'alimentation (25), et la commande de l'électrode de drain du premier transistor de commande (DT1) de manière à ce qu'elle soit déconnectée de la première électrode du premier dispositif électroluminescent (22) ;
à la première étape d'écriture, la commande du signal de données de la première borne d'écriture de données (Data1) de manière à ce qu'il soit écrit dans l'électrode de source du premier transistor d'attaque (DT1), la commande de l'électrode de drain du premier transistor d'attaque (DT1) de manière à ce qu'elle soit mise en conduction avec l'électrode de grille du premier transistor d'attaque (DT1), la commande de l'électrode de source du premier transistor d'attaque (DT1) de manière à ce qu'elle soit déconnectée de la première borne d'alimentation (25), et la commande de l'électrode de drain du premier transistor d'attaque (DT1) de manière à ce qu'elle soit déconnectée de la première électrode du premier dispositif électroluminescent (22) ;
à la seconde étape de réinitialisation, la commande du signal de la seconde borne de tension initialisée (VINP) de manière à ce qu'il soit transmis à l'électrode de grille du deuxième transistor d'attaque (DT2) et à la seconde électrode du second condensateur (C2), la commande de l'électrode de source du deuxième transistor d'attaque (DT2) de manière à ce qu'elle soit déconnectée de la seconde borne d'alimentation (26), et la commande de l'électrode de drain du deuxième transistor d'attaque (DT2) de manière à ce qu'elle soit déconnectée de la première électrode du deuxième dispositif électroluminescent (23) ;
à la seconde étape d'écriture, la commande du signal de données de la seconde borne d'écriture de données (Data2) de manière à ce qu'il soit écrit dans l'électrode de source du deuxième transistor d'attaque (DT2), la commande de l'électrode de drain du deuxième transistor d'attaque (DT2) de manière à ce qu'elle soit mise en conduction avec l'électrode de grille du deuxième transistor d'attaque (DT2), la commande de l'électrode de source du deuxième transistor d'attaque (DT2) de manière à ce qu'elle soit déconnectée de la seconde borne d'alimentation (26), et la commande de l'électrode de drain du deuxième transistor d'attaque (DT2) de manière à ce qu'elle soit déconnectée de la première électrode du deuxième dispositif électroluminescent (23) ;
à l'étape d'émission de lumière, le procédé comprend en outre : la commande de l'électrode de source du premier transistor d'attaque (DT1) de manière à ce qu'elle soit mise en conduction avec la première borne d'alimentation (25), la commande de l'électrode de drain du premier transistor d'attaque (DT1) de manière à ce qu'elle soit mise en conduction avec la première électrode du premier dispositif électroluminescent (22), la commande de l'électrode de source du deuxième transistor d'attaque (DT2) de manière à ce qu'elle soit mise en conduction avec la seconde borne d'alimentation (26), et la commande de l'électrode de drain du deuxième transistor d'attaque (DT2) de manière à ce qu'elle soit mise en conduction avec la première électrode du deuxième dispositif électroluminescent (23) ; et
la seconde étape de réinitialisation et la première étape d'écriture se déroulent de manière synchrone.
